(19) Europäisches Patentamt
European Patent Office
Office européen des brevets

(11) **EP 2 333 953 B1**

(12) **EUROPÄISCHE PATENTSCHRIFT**

(45) Veröffentlichungstag und Bekanntmachung des Hinweises auf die Patenterteilung:
**03.12.2014  Patentblatt 2014/49**

(51) Int Cl.:
*H03G 3/34* (2006.01)  *H04B 1/10* (2006.01)

(21) Anmeldenummer: **10013269.5**

(22) Anmeldetag: **04.10.2010**

(54) **Verfahren und Vorrichtung zum Aktivieren bzw. Deaktivieren eines Signals zur Unterdrückung eines Empfangssignals**

Method and device for activating and deactivating a signal for suppressing a received signal

Procédé et dispositif d'activation et désactivation d'un signal pour supprimer un signal de réception

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: 30.10.2009  DE 102009051369
29.01.2010  DE 102010006171

(43) Veröffentlichungstag der Anmeldung:
**15.06.2011  Patentblatt 2011/24**

(73) Patentinhaber: **Rohde & Schwarz GmbH & Co. KG**
**81671 München (DE)**

(72) Erfinder:
• **Krall, Christoph, Dr.**
**81673 München (DE)**
• **Gebauer, Thomas**
**80333 München (DE)**

(74) Vertreter: **Körfer, Thomas et al**
**Mitscherlich PartmbB**
**Patent- und Rechtsanwälte**
**Postfach 33 06 09**
**80066 München (DE)**

(56) Entgegenhaltungen:
EP-A2- 1 843 467    US-A- 4 371 981
US-A- 4 388 731    US-A- 5 365 592

EP 2 333 953 B1

**Beschreibung**

Die Erfindung betrifft ein Verfahren und eine Vorrichtung zum Aktivieren bzw. Deaktivieren eines Signals zur Unterdrückung eines Empfangssignals.

Die im Flugfunk empfangenen Signale enthalten neben dem auf einer bestimmten Frequenz übertragenen Nutzsignal auch einen Rauschsignalanteil. Aus der EP 1 843 467 A2 geht eine Vorrichtung zur Erzeugung eines Signals zur Unterdrückung des Empfangssignals, ein so genanntes Squelch-Signal, auf der Basis der Ermittlung des Signal-Rausch-Abstands hervor. Hierzu werden der Betrag und die Phase des Empfangssignals ermittelt, wobei der Betrag des Empfangssignals ein Maß für den Signalanteil und die zeitliche Änderung der Phase des Empfangssignals ein Maß für den Rauschanteil ist.

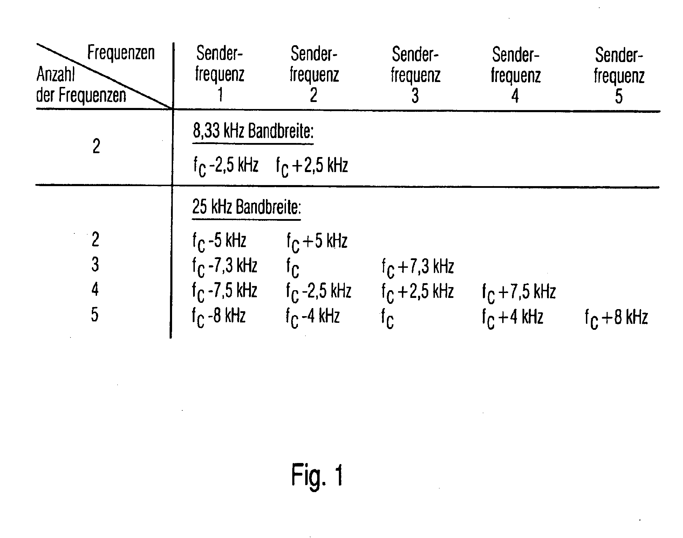

Bei einem sog. CLIMAX-Betrieb ist das von jeder Bodenstation ausgestrahlte Audiosignal ein identisches amplitudenmoduliertes Funksignal. Die Frequenz des Audiosignals ist entweder bei allen Bodenstationen identisch oder bei jeder Bodenstation unterschiedlich. Bei unterschiedlicher Frequenzlage liegt die Frequenz des Audiosignals entweder auf der Trägerfrequenz oder in einem bestimmten positiven oder negativen Frequenzabstand zur Trägerfrequenz. Die unterschiedlichen Frequenzen gehen aus Fig. 1 für unterschiedliche Frequenzbandbreiten und für eine unterschiedliche Anzahl unterschiedlicher Frequenzen hervor.

In einem im Cockpit des Flugzeugs befindlichen Empfänger wird ein Audiosignal empfangen, das aus einer Überlagerung von mehreren Audiosignalen mit jeweils unterschiedlicher Frequenz besteht. Die Überlagerung von mehreren Audiosignalen mit jeweils unterschiedlichen Frequenzen führt im empfangenen Audiosignal zur Ausbildung von Signalanteilen, die jeweils eine der Differenzfrequenz zwischen zwei empfangenen Frequenzen entsprechende Frequenz (Grundwellenanteil) und/oder eine dem ganzzahligen Vielfachen der Differenzfrequenz entsprechende Frequenz (Oberwellenanteil) aufweist. Wie weiter unten noch im Detail gezeigt wird, weisen die Phasen der Signalanteile des empfangenen Audiosignals an den einzelnen Differenzfrequenzen jeweils einen stark nichtlinearen Verlauf auf. Das Spektrum über den Betrag und die erste Ableitung der Phase des empfangenen Audiosignals enthält an den einzelnen Differenzfrequenzen, wie auch weiter unten im Detail noch gezeigt wird, Spektrallinien, die für den Pilot als unerwünschte Schlagtöne zu hören sind. Insbesondere die Spektrallinien im Verlauf der ersten Ableitung der Phase des empfangenen Audiosignals überlagern sich zum Phasenanteil durch das Rauschen und verschlechtern den Signal-Rausch-Abstands des empfangenen Audiosignals erheblich. Eine Bestimmung des Signals zur Unterdrückung des Empfangssignals auf der Basis der Ermittlung des Signal-Rausch-Abstands führt folglich u.U. zu einer fehlerhaften Aktivierung des Signals zur Unterdrückung des Empfangssignals und scheidet deshalb bei einem CLIMAX-Betrieb aus.

Aus der US 4,371,981 A geht eine Vorrichtung zur Erzeugung eines Squelch-Signals für den CLIMAX-Betrieb auf der Basis der Ermittlung des Signal-Rausch-Abstands hervor, bei der aus dem bandbegrenzten Zwischenfrequenzspektrum des Empfangssignals, das neben den Spektralanteilen des Rauschens auch die Spektrallinien des Nutzsignals an den Differenzfrequenzen enthält, mittels eines Hüllkurven-Detektors ein Zeitsignal mit einem der Hüllkurve des Zwischenfrequenzspektrums entsprechenden Zeitverlauf erzeugt. Während der Signalanteil des Empfangsanteils aus dem Spitzenwert des vom Hüllkurven-Detektor erzeugten Zeitsignals gewonnen wird, wird der Rauschanteil des Empfangssignals aus dem Mittelwert des vom Hüllkurven-Detektor erzeugten Zeitsignals ermittelt. Bei dieser Vorrichtung gehen die Nutzsignalanteile des vom Hüllkurven-Detektor erzeugten Zeitsignals in den ermittelten Mittelwert ein und verfälschen somit auch den daraus ermittelten Rauschanteil des Empfangssignals, was zu einer fehlerhaften Aktivierung des Squelch-Signals führt.

Bei einer in der US 4,388,731 A offenbarten Vorrichtung zur Erzeugung eines Squelch-Signals für den CLIMAX-Betrieb wird das Empfangssignal in jeweils drei parallelen Signalpfaden einer Bandpassfilterung und anschließenden Mittelwertbildung unterworfen, wobei die Mittelfrequenzen der in den einzelnen Signalpfaden jeweils vorgesehenen Bandpass-Filter jeweils einer unterschiedlichen Differenzfrequenz der im CLIMAX-Betrieb auftretenden Differenzfrequenzen von zum Nutzsignal gehörigen Spektrallinien entspricht. Für die Aktivierung des Squelch-Signals wird der niedrigste Mittelwert aller in den drei Signalpfaden jeweils ermittelten Mittelwerte herangezogen, der dem Mittelwert desjenigen Signalpfades entspricht, in dem die auftretenden Differenzfrequenzen der Nutzsignalspektrallinien außerhalb der Bandbreite des jeweiligen Bandpass-Filters liegen. Eine derartige Vorrichtung zur Erzeugung eines Squelch-Signals eignet sich, wie auch aus der Offenbarung der US 4,388,731 A klar und eindeutig hervorgeht, nur für einen Climax-Betrieb mit bis zu zwei Differenzfrequenzen.

Aus der US 5,365,592 A geht eine Vorrichtung zur Detektion der Anwesenheit eines Nutzsignals in einem verrauschten Empfangssignal im Basisband hervor. Hierzu werden Verfahren der Fourier-Transformation, der Cepstrum-Ermittlung, der frequenzselektiven Filterung, der Fensterung im Zeit- und Frequenzbereich und der Schwellwert-Detektion verwendet.

Aufgabe der Erfindung ist es deshalb, ein Verfahren und eine Vorrichtung zur Unterdrückung des Empfangssignals mit Zweiträger-Signalanteilen im Flugfunk, insbesondere für den CLIMAX-Betrieb, zu schaffen.

Die Aufgabe wird durch ein Verfahren zur Erzeugung eines Signals zur Unterdrückung eines Empfangssignals mit den Merkmalen des Patentanspruchs 1 und durch eine Vorrichtung zur Erzeugung eines Signals zur Unterdrückung eines Empfangssignals mit den Merkmalen des Patentanspruchs 19 gelöst. Vorteilhafte technische Erweiterungen sind in den abhängigen Patentansprüchen aufgeführt.

Erfindungsgemäß wird das empfangene Audiosignal bandpassgefiltert, so dass im Betrags- und Differenzphasenspektrum jeweils entweder nur noch die Spektrallinien an den einzelnen Differenzfrequenzen im Grundwellenbereich oder die Spektrallinien an den einzelnen Differenzfrequenzen im Grundwellenbereich und in einem bestimmten Oberwellenbereich auftreten (Zweiträger-Signalanteile).

Die hoch frequenzselektive Identifizierung von periodischen Signalanteilen im empfangenen Audiosignal erfolgt durch Ermittlung der Werte des Leistungsdichtespektrums an den einzelnen Differenzfrequenzen des Empfangssignals.

In einer ersten Ausführungsform der Erfindung wird hierzu das gefilterte Audiosignal autokorreliert. Anschließend werden die Werte der Fourier-Transformierten der ermittelten Autokorrelationsfunktion an den einzelnen Differenzfrequenzen bestimmt.

In einer zweiten Ausführungsform der Erfindung werden hierzu die Werte der Fourier-Transformierten des gefilterten Empfangssignals an den einzelnen Differenzfrequenzen ermittelt. Anschließend wird der Betrag der ermittelten Werte der Fourier-Transformierten des gefilterten Empfangssignals an den einzelnen Differenzfrequenzen gebildet.

Dieses Leistungsdichtespektrum weist einerseits keine Phaseninformationen auf und enthält andererseits mit einer hohen Frequenzselektivität die zu den einzelnen periodischen Signalanteilen jeweils gehörigen Spektrallinien, deren Spektralpegel sich deutlich von den Pegeln der Rauschsignalanteile absetzen.

Werden die ermittelten Werte des Leistungsdichtespektrums an den einzelnen Differenzfrequenzen, anschließend mit einem Schwellwert verglichen so ist die Empfangsqualität des vom Rauschen separierten Nutzsignals im empfangenen Audiosignal ungenügend, wenn der jeweilige Wert unter den Schwellwert sinkt. In diesem Fall wird ein Signal zur Unterdrückung des empfangenen Audiosignals aktiviert.

Da sowohl im Spektrum des Betrags des Empfangssignals als auch im Spektrum der ersten zeitlichen Ableitung der Phase des Empfangssignals an den jeweiligen Differenzfrequenzen und deren höheren Harmonischen Spektrallinien des periodischen Nutzsignalanteils mit einem gegenüber dem Pegel der Rauschsignalanteile höheren Pegel aufweisen, wird in einer ersten Variante der Erfindung der Betrag oder die erste zeitliche Ableitung des Empfangssignals für die Ermittlung des Signals zur Unterdrückung des Empfangssignals verwendet. In einer zweiten Variante der Erfindung werden der Betrag und die erste zeitliche Ableitung der Phase des Empfangssignals gleichzeitig verwendet, indem die Signalverarbeitungskette doppelt - die Eine für den Betrag des Empfangssignals und die Andere für die erste zeitliche Ableitung der Phase des Empfangssignals - ausgeführt ist. Die Vergleicher in den beiden Signalverarbeitungsketten arbeiten jeweils mit einem unterschiedlichen Schwellwert, der an das Pegelniveau im jeweiligen Leistungsdichtspektrum angepasst ist. Zur Erzeugung des Signals zur Unterdrückung des Empfangssignals werden die Ausgangssignale der beiden Signalpfade bevorzugt miteinander logisch UND-verknüpft.

In einer ersten Untervariante der Erfindung wird der Größte aller an den einzelnen Differenzfrequenzen jeweils ermittelten Werte des Leistungsdichtespektrums über einen Maximalwertdetektor bestimmt und dem Vergleicher zugeführt. Die erste Untervariante der Erfindung stellt die sicherste Methode zur Bestimmung der Empfangsqualität des vom Rauschen separierten Nutzsignals im empfangenen Audiosignal und damit eines Signals zur Unterdrückung des Empfangssignals dar.

In einer zweiten Untervariante der Erfindung werden mehrere an einzelnen Differenzfrequenzen im Grundwellenbereich jeweils ermittelte Werte des Leistungsdichtespektrums jeweils einem Vergleicher zugeführt. Die Ausgangssignale der einzelnen Vergleicher werden anschließend einer Logik-Einheit zur gezielten Auswahl von Vergleichsergebnisse an bestimmten vorher festgelegten Differenzfrequenzen geführt. Mit der zweiten Untervariante der Erfindung wird das Signal zur Unterdrückung des Empfangssignals auf der Basis der Empfangsqualität der von mehreren, vorher festgelegten Sendern jeweils empfangenen Signale bestimmt.

In einer dritten Untervariante der Erfindung werden mehrere an einzelnen Differenzfrequenzen im Grundwellenbereich und Oberwellenbereich jeweils ermittelte Werte des Leistungsdichtespektrums jeweils einem Vergleicher zugeführt. Die Ausgangssignale der einzelnen Vergleicher werden anschließend ebenfalls einer Logik-Einheit zur gezielten Auswahl von Vergleichsergebnissen an bestimmten vorher festgelegten Differenzfrequenzen geführt. Mit der dritten Untervariante der Erfindung wird das Signal zur Unterdrückung des Empfangssignals auf der Basis der Empfangsqualität der aus Grund- und Oberwellenanteil bestehenden und von mehreren, vorher festgelegten Sendern jeweils empfangenen Signale bestimmt.

Zwischen dem bzw. den Bandpassfilter(n) und der(den) Funktionseinheit(en) zur Bestimmung von Werten eines Leistungsdichtespektrums des gefilterten Empfangssignals ist bevorzugt jeweils eine Funktionseinheit zur automatischen Signalpegelanpassung geschaltet, der einerseits einen Überlauf (overflow) des Signals in den einzelnen Signalverarbeitungsstufen der bevorzugt digital realisierten Signalverarbeitungskette verhindern soll und andererseits ein optimales Ausnutzen des Dynamikbereichs in den einzelnen Signalverarbeitungsstufen der Signalverarbeitungskette gewährleisten soll.

Die untere und obere Grenzfrequenz des(r) Bandpassfilter(s) entsprechen bevorzugt jeweils der niedrigsten und höchsten Differenzfrequenz im Grundwellenbereich oder im Grundwellenbereich zuzüglich eines bestimmten Anteils im Oberwellenbereich.

Um ein ständiges Aktivieren und Deaktivieren des Signals zur Unterdrückung des Empfangssignals - sogenannter "Schnattervorgang" de(s)r als Schalter agierenden Vergleicher(s) - zu verhindern, weisen der(die) Vergleicher vorzugsweise eine Hysterese mit einem oberen Schwellwert zur Deaktivierung des Signals zur Unterdrückung des Empfangssignals auf, falls der jeweilige Wert des Leistungsdichtespektrums größer als der obere Schwellwert ist. Ein unterer Schwellwert ist zur Aktivierung des Signals zur Unterdrückung des Empfangssignals vorhanden, falls der jeweilige Wert des Leistungsdichtespektrums kleiner als der untere Schwellwert ist.

Die Differenzfrequenzen, an denen der Wert des Leistungsdichtespektrums jeweils ermittelt wird, ergeben sich als Differenzen der Frequenzen der einzelnen Bodenstationen, die gemäß dem CLIMAX-Standard ausgewählt werden.

Zur Erhöhung der Frequenzselektivität bei Frequenzschwankungen der Differenzfrequenzen aufgrund von Frequenzdriften der Oszillatoren in dem Sender und dem Empfänger und/oder aufgrund des Dopplereffekts, erfolgt die Auswertung des Leistungsdichtespektrum bevorzugt nicht nur an den Referenzfrequenzen des CLIMAX-Standards, sondern auch an zu den einzelnen Differenzfrequenzen geeignet beabstandeten Frequenzen.

Die einzelnen Ausführungsformen, Varianten und Untervarianten des erfindungsgemäßen Verfahrens und der erfindungsgemäßen Vorrichtung zur Erzeugung eines Signals zur Unterdrückung eines Empfangssignals werden im Folgenden anhand der Zeichnung beispielhaft im Detail erläutert. Die Figuren der Zeichnung zeigen:

Fig. 1          eine Tabelle mit verwendeten Frequenzen nach dem CLIMAX-Standard,

Fig. 2A          ein Blockdiagramm der ersten Variante der ersten Ausführungsform der erfindungsgemäßen Vorrichtung zur Erzeugung eines Signals zur Unterdrückung eines Empfangssignals,

Fig. 2B          ein Blockdiagramm der zweiten Variante der ersten Ausführungsform der erfindungsgemäßen Vorrichtung zur Erzeugung eines Signals zur Unterdrückung eines Empfangssignals,

Fig. 3A          ein Blockdiagramm der ersten Variante der zweiten Ausführungsform der erfindungsgemäßen Vorrichtung zur Erzeugung eines Signals zur Unterdrückung eines Empfangssignals,

Fig. 3B          ein Blockdiagramm der zweiten Variante der zweiten Ausführungsform der erfindungsgemäßen Vorrichtung zur Erzeugung eines Signals zur Unterdrückung eines Empfangssignals,

Fig. 4A          ein Flussdiagramm der ersten Ausführungsform des erfindungsgemäßen Verfahrens zur Erzeugung eines Signals zur Unterdrückung eines Empfangssignals,

Fig. 4B          ein Flussdiagramm der zweiten Ausführungsform des erfindungsgemäßen Verfahrens zur Erzeugung eines Signals zur Unterdrückung eines Empfangssignals,

Fig. 5          ein Zeitdiagramm eines Empfangssignals mit zwei periodischen Nutzsignalanteilen und einem stochastischen Rauschsignalanteil,

Fig. 6A,6B          ein Frequenzdiagramm des Betrags und der ersten zeitlichen Ableitung der Phase eines Empfangssignals mit zwei periodischen Nutzsignalanteilen und einem stochastischen Rauschsignalanteil,

Fig. 7A,7B          ein Zeigerdiagramm der beiden periodischen Nutzsignalanteile im Empfangssignal und ein Zeitdiagramm des Phasenverlaufs des einzig aus beiden periodischen Nutzsignalanteilen zusammengesetzten Empfangssignals,

Fig. 8          ein Frequenzdiagramm des bandpassgefilterten Empfangssignals,

Fig. 9          ein Zeitdiagramm der Autokorrelationsfunktion des Empfangssignals,

Fig. 10          ein Frequenzdiagramm des Leistungsdichtespektrums des Empfangssignals,

Fig. 11          ein Frequenzdiagramm einer Spektrallinie des Leistungsdichtespektrums in Abhängigkeit einer Frequenzschwankung,

Fig. 12          ein Frequenzdiagramm von benachbarten Spektrallinien des Leistungsdichtespektrum bei Frequenzschwankungen,

Fig. 13     ein Pegeldiagramm mit den Anwendungsfeldern von Squelch-Signalerzeugung auf der Basis einer S/N-R-Messung und einer Leistungsdichtespektrum-Messung,

Fig. 14A     ein Blockdiagramm einer zweiten bzw. dritten Untervariante der ersten Variante der ersten Ausführungsform der erfindungsgemäßen Vorrichtung zur Erzeugung eines Signals zur Unterdrückung eines Empfangssignals und

Fig. 14B     ein Blockdiagramm einer zweiten bzw. dritten Untervariante der ersten Variante der zweiten Ausführungsform der erfindungsgemäßen Vorrichtung zur Erzeugung eines Signals zur Unterdrückung eines Empfangssignals.

Bevor die einzelnen Ausführungsformen, Varianten und Untervarianten der erfindungsgemäßen Vorrichtung und des erfindungsgemäßen Verfahrens zur Erzeugung eines Signals zur Unterdrückung eines Empfangssignals im Detail erläutert werden, werden im Folgenden die mathematischen Grundlagen der Erfindung hergeleitet:

Zur Vereinfachung der systemtheoretischen Grundlagen der Erfindung wird die Überlagerung eines ersten Audiosignals $x_1(t)$ mit der Trägerfrequenz $\omega_C - \dfrac{\Delta\omega}{2}$, das von einer ersten Bodenstation ausgesendet wird, und eines zweiten Audiosignals $x_2(t)$ mit der Trägerfrequenz $\omega_C + \dfrac{\Delta\omega}{2}$ im Empfänger betrachtet, beispielsweise das CLIMAX-System bei 8,33 kHz Frequenzträgerbreite und den Frequenzen $f_C \pm 2,5 kHz$ oder das CLIMAX-System bei 25 KHz Frequenzträgerbreite und den Frequenzen $f_C \pm 5 kHz$ der Fig. 1. Bei beiden Signalen handelt es sich um ein amplitudenmoduliertes Signal, bei dem das identische analoge Audiofrequenz-Signal $a(t)$ auf den Träger moduliert wird. Das zweite Audiosignal $x_2(t)$ ist gegenüber dem ersten Audiosignal $x_1(t)$ um einen Dämpfungsfaktor $k$ ($0 < k < 1$) gedämpft, da die Distanz des Flugzeugs zur zweiten Bodenstation im Normalfall ungleich der Distanz des Flugzeugs zur ersten Bodenstation ist und unterschiedliches Pfad-Fading zwischen den beiden Bodenstationen und dem Flugzeug herrscht.

Das hochfrequente Empfangssignal $x_{RF}(t)$ als Überlagerung des ersten Audiosignals $x_1(t)$ und des zweiten Audiosignals $x_2(t)$ ergibt sich gemäß Gleichung (1). Unterschiedliche Zeitverzögerungen in den Übertragungsstrecken zwischen den beiden Bodenstationen und dem Flugzeug werden vernachlässigt.

$$x_{RF}(t) = x_1(t) + k \cdot x_2(t) = a(t) \cdot \cos\left(\left(\omega_C - \frac{\Delta\omega}{2}\right) \cdot t\right) + k \cdot a(t) \cdot \cos\left(\left(\omega_C + \frac{\Delta\omega}{2}\right) \cdot t\right)$$

$$(1)$$

Nach der Demodulation des hochfrequenten Empfangssignals $x_{RF}(t)$ ins komplexe Basisband erhält man das Empfangssignal im Basisband $x_{BB}(t)$ gemäß Gleichung (2).

$$x_{BB}(t) = a(t) \cdot \left(e^{-j\frac{\Delta\omega}{2} \cdot t} + k \cdot e^{j\frac{\Delta\omega}{2} \cdot t}\right) = x_{1BB}(t) + x_{2BB}(t)$$

$$= a(t) \cdot \left(\cos\left(\frac{\Delta\omega}{2} \cdot t\right) \cdot (1 + k) + j \cdot \sin\left(\frac{\Delta\omega}{2} \cdot t\right) \cdot (-1 + k)\right) \qquad (2)$$

Der Betrag $|x_{BB}(t)|$ des Empfangssignals im Basisband $x_{BB}(t)$ ergibt sich gemäß Gleichung (3).

$$|x_{BB}(t)| = \sqrt{\mathrm{Re}\{x_{BB}(t)\}^2 + \mathrm{Im}\{x_{BB}(t)\}^2} =$$

$$= a(t) \cdot \sqrt{\cos^2(\frac{\Delta\omega}{2} \cdot t) \cdot (1 + 2k + k^2) + \sin^2(\frac{\Delta\omega}{2} \cdot t) \cdot (1 - 2k + k^2)} =$$

$$= a(t) \cdot \sqrt{1 + k^2 + 2k \cdot \cos(\Delta\omega \cdot t)} \qquad (3)$$

Zur Vereinfachung der weiteren mathematischen Herleitung wird ohne Beschränkung der Allgemeinheit ein relativer Dämpfungsfaktor $k$ von eins angenommen. Der Betrag $|x_{BB}(t)|$ des Empfangssignals im Basisband $x_{BB}(t)$ ergibt sich somit gemäß Gleichung (4).

$$|x_{BB}(t)| = a(t) \cdot \sqrt{2 + 2 \cdot \cos(\Delta\omega \cdot t)} =$$

$$= a(t) \cdot \sqrt{4 \cdot \cos^2(\frac{\Delta\omega}{2} \cdot t)} = 2 \cdot a(t) \cdot \left|\cos(\frac{\Delta\omega}{2} \cdot t)\right| \qquad (4)$$

Die periodische Funktion $\left|\cos(\frac{\Delta\omega}{2} \cdot t)\right|$ kann gemäß Gleichung (5) in eine Fourier-Reihe zerlegt werden.

$$\left|\cos(\frac{\Delta\omega}{2} \cdot t)\right| \approx \frac{2}{\pi} \cdot (1 + \frac{2}{3} \cdot \cos(\Delta\omega \cdot t) - \frac{2}{15} \cdot \cos(2 \cdot \Delta\omega \cdot t) + \frac{2}{35} \cdot \cos(3 \cdot \Delta\omega \cdot t) \overline{+} ...)$$

$$(5)$$

Das Spektrum $|X_{BB}(\omega)|$ zum Betrag $|x_{BB}(t)|$ des Empfangssignals im Basisband $x_{BB}(t)$, das ein Maß für den Nutzsignalanteil im Empfangssignal ist, ergibt sich gemäß Gleichung (6), wobei $A(\omega)$ das Spektrum des analogen Audiofrequenz-Signals $a(t)$ ist.

$$|X_{BB}(\omega)| = \frac{4}{\pi} \cdot A(\omega) * \left(1 + \frac{1}{3} \cdot \delta(\omega \pm \Delta\omega) - \frac{1}{15} \cdot \delta(\omega \pm 2 \cdot \Delta\omega) + \frac{1}{35} \cdot \delta(\omega \pm 3 \cdot \Delta\omega) \overline{+} ...\right) =$$

$$= \frac{4}{\pi} \cdot (A(\omega) + \frac{1}{3} \cdot A(\omega \pm \Delta\omega) - \frac{1}{15} \cdot A(\omega \pm 2 \cdot \Delta\omega) + \frac{1}{35} \cdot A(\omega \pm 3 \cdot \Delta\omega) \overline{+} ...)$$

$$(6)$$

Wie aus Gleichung (6) hervorgeht, weist das Betragsspektrum $|X_{BB}(\omega)|$ zum Empfangssignal im Basisband $X_{BB}(t)$ bei der Nullfrequenz, bei der Differenzfrequenz $\Delta\omega$ zwischen den beiden Trägerfrequenzen $\omega_C \pm \dfrac{\Delta\omega}{2}$ der beiden Audiosignale $x_1(t)$ und $x_2(t)$ und bei höher Harmonischen $n \cdot \Delta\omega$ der Differenzfrequenz (mit $n > 1$) jeweils eine Spektrallinie auf.

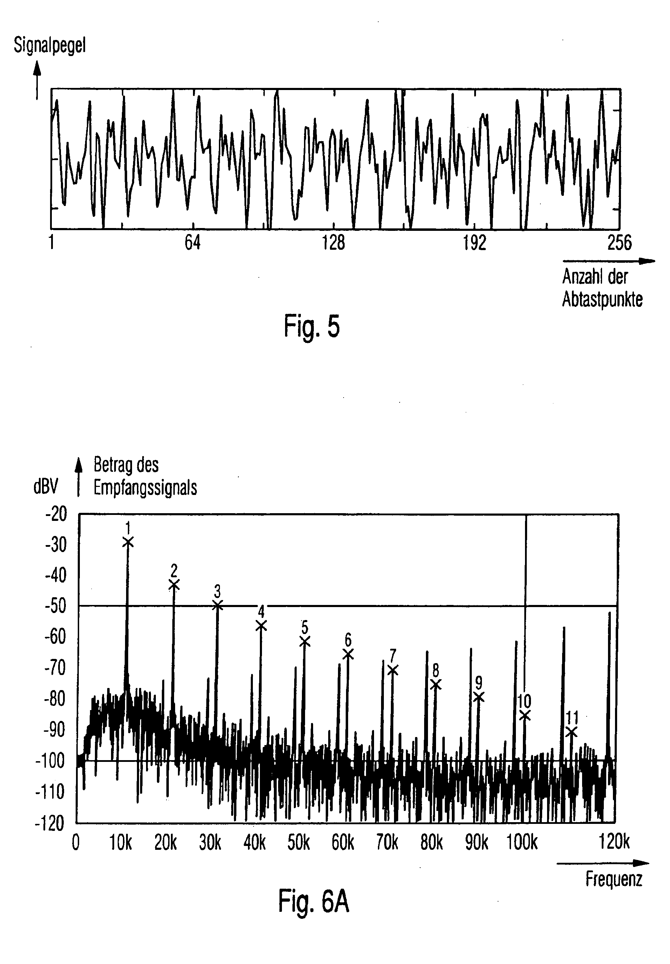

In Fig. 6A ist das Betragsspektrum $|X_{BB}(\omega)|$ zum Empfangssignal im Basisband $x_{BB}(t)$ bei einem CLIMAX-Betrieb mit 25 kHz Frequenzträgerbreite und den Frequenzen $f_C \pm 5kHz$ dargestellt. Deutlich sind die Spektrallinien bei der Differenzfrequenz 10 kHz und bei Vielfachen der Differenzfrequenz zu erkennen.

Wird ein beliebiger relativer Dämpfungsfaktor $k$ ($0 < k < 1$) angenommen, so ist die mathematische Beziehung für den Betrag $|x_{BB}(t)|$ des Empfangssignals im Basisband $x_{BB}(t)$ gemäß Gleichung (3), die ebenfalls eine Periodizität aufweist, in eine Fourier-Reihe zu zerlegen. Die Berechnung der Fourier-Koeffizienten für die mathematische Funktion in Gleichung (3) gestaltet sich aber deutlich schwieriger als die Fourier-Reihen-Zerlegung der Gleichung (4) und wird deshalb hier nicht weiterverfolgt. Da es sich aber bei der mathematischen Funktion in Gleichung (3) um eine gerade Funktion handelt, weist die zugehörige Fourier-Reihe ebenfalls nur Cosinus-Terme auf. Das zugehörige Betragsspektrum weist folglich auch Dirac-Impulse bei der Differenzfrequenz $\Delta\omega$ und bei den höher Harmonischen $n \cdot \Delta\omega$ der Differenzfrequenz $\Delta\omega$ auf, deren Amplituden aber zu den Amplituden der Dirac-Impulse im Fall eines relativen Dämpfungsfaktors $k$ von eins in Gleichung (6) differieren.

Als Maß für den Rauschanteil im Empfangssignal wird anstelle des Phasenspektrums $\arg\{X_{BB}(\omega)\}$ des Empfangssignals im Basisband $x_{BB}(t)$ das Spektrum zur ersten zeitlichen Ableitung $\dfrac{d\,\arg\{x_{BB}(t)\}}{dt}$ der Phase $\arg\{x_{BB}(t)\}$ des Empfangssignals im Basisband $x_{BB}(t)$ verwendet.

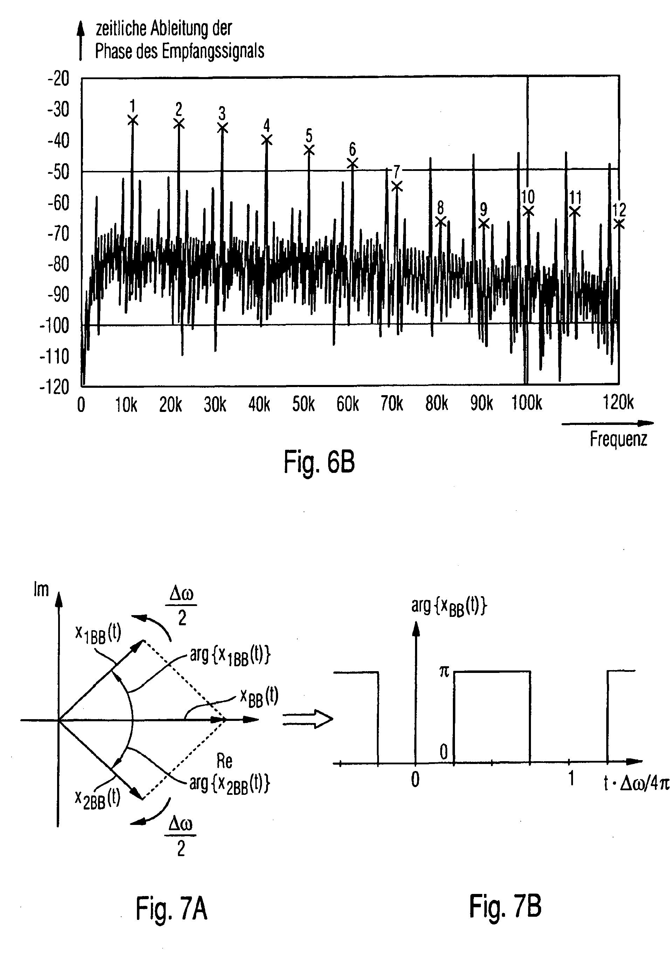

Zur Vereinfachung der mathematischen Herleitung wird wiederum ein relativer Dämpfungsfaktor $k$ von eins angenommen. Betrachtet man ausgehend von Gleichung (2) den Phasenverlauf $\arg\{x_{1BB}(t)\}$ des ersten Audiosignals im Basisband $x_{1BB}(t)$ und den Phasenverlauf $\arg\{x_{2BB}(t)\}$ des zweiten Audiosignals im Basisband $x_{2BB}(t)$ in Fig. 7A, deren komplexe Drehzeiger jeweils mit der Frequenz $+\dfrac{\Delta\omega}{2}$ bzw. $-\dfrac{\Delta\omega}{2}$ drehen, so ergibt sich der Phasenverlauf $arg\{x_{BB}(t)\}$ der Empfangssignals im Basisband $x_{BB}(t)$ als Phasenverlauf des resultierenden Drehzeigers aus den beiden zum ersten Audiosignal im Basisband $x_{1BB}(t)$ und zum zweiten Audiosignal im Basisband $x_{2BB}(t)$ jeweils gehörigen Drehzeigern. Der Phasenverlauf $arg\{x_{BB}(t)\}$ des Empfangssignals im Basisband $x_{BB}(t)$ springt gemäß Gleichung (7), wie auch aus Fig. 7B zu erkennen ist, mit einer Periodizität von $\dfrac{4\pi}{\Delta\omega}$ zwischen den beiden Werten 0 und $\pi$.

$$\arg\{x_{BB}(t)\} = \begin{cases} 0 \\ \pi \end{cases} \text{für} \begin{array}{l} (4(n-1)+3)\cdot\dfrac{\pi}{\Delta\omega} \le t < (4n+1)\cdot\dfrac{\pi}{\Delta\omega} \\ (4n+1)\cdot\dfrac{\pi}{\Delta\omega} \le t < (4n+3)\cdot\dfrac{\pi}{\Delta\omega} \end{array} \quad \text{mit} \quad n = 0, 1, 2, \ldots$$

$$(7)$$

Die erste zeitliche Ableitung $\dfrac{d\,\arg\{x_{BB}(t)\}}{dt}$ des Phasenverlaufs $arg\{x_{BB}(t)\}$ des Empfangssignals im Basisband $x_{BB}(t)$ führt gemäß Gleichung (8) zu Dirac-Impulsen mit alternierenden Vorzeichen an den Sprungstellen des Phasenverlaufs $arg\{x_{BB}(t)\}$ des Empfangssignals im Basisband $x_{BB}(t)$.

$$\frac{d\arg\{x_{BB}(t)\}}{dt} = -\pi \cdot \sum_{n=-\infty}^{+\infty} (-1)^n \cdot \delta(t - \frac{(2n-1)\cdot\pi}{\Delta\omega}) \qquad (8)$$

Da es sich bei der ersten zeitlichen Ableitung $\dfrac{d\arg\{x_{BB}(t)\}}{dt}$ des Phasenverlaufs $\arg\{x_{BB}(t)\}$ des Empfangssignals im Basisband $x_{BB}(t)$ um ein periodisches Signal handelt, kann auch hier eine Fourier-Reihe gemäß Gleichung (9) entwickelt werden.

$$\frac{d\arg\{x_{BB}(t)\}}{dt} = -\Delta\omega \cdot \left(\frac{1}{2} + \sum_{n=-\infty}^{+\infty} (-1)^n \cdot \cos(n\cdot\Delta\omega\cdot t)\right) \qquad (9)$$

Das Spektrum $\dfrac{d\arg\{X_{BB}(\omega)\}}{d\omega}$ zur ersten zeitlichen Ableitung $\dfrac{d\arg\{x_{BB}(t)\}}{dt}$ der Phase $\arg\{x_{BB}(t)\}$ des Empfangssignals im Basisband $x_{BB}(t)$ ergibt sich somit gemäß Gleichung (10).

$$\frac{d\arg\{X_{BB}(\omega)\}}{d\omega} = \frac{\Delta\omega}{2}\cdot\left(1 - \delta(\omega\pm\Delta\omega) + \delta(\omega\pm 2\cdot\Delta\omega) - \delta(\omega\pm 3\cdot\Delta\omega)\pm...\right)$$

$$(10)$$

Analog zum Betragsspektrum weist auch das Spektrum $\dfrac{d\arg\{X_{BB}(\omega)\}}{d\omega}$ zur ersten zeitlichen Ableitung $\dfrac{d\arg\{x_{BB}(t)\}}{dt}$ der Phase $\arg\{x_{BB}(t)\}$ des Empfangssignals im Basisband $x_{BB}(t)$ gemäß Gleichung (10), wie auch aus Fig. 6B ersichtlich ist, bei der Nullfrequenz, bei der Differenzfrequenz, $\Delta\omega$ und bei den höher Harmonischen $n\cdot\Delta\omega$ der Differenzfrequenz jeweils eine Spektrallinie auf.

Der Betrag $|x_{BB}(t)|$ des Empfangssignals im Basisband $x_{BB}(t)$ und die Phase $\arg\{x_{BB}(t)\}$ des Empfangssignals im Basisband $x_{BB}(t)$ werden entweder alternativ einem Bandpassfilter oder gleichzeitig jeweils einem Bandpassfilter zur Ausblendung von Spektrallinien im gesamten Oberwellenbereich oder nur in einem bestimmten Segment des Oberwellenbereichs der Differenzfrequenz zugeführt. Die untere und obere Grenzfrequenz der jeweiligen Bandpassfilter ist an der Kleinsten und der Größten aller nach dem CLIMAX-Standard auftretenden Differenzfrequenzen im Fall der Ausblendung des gesamten Oberwellenbereichs oder an die untere Grenzfrequenz des Segments des Oberwellenbereichs, der ausgeblendet werden soll, orientiert.

Nach einer Signalpegelanpassung erfolgt in einer ersten Ausführungsform der Erfindung die Ermittlung der Autokorrelationsfunktion $R_{xx}(m)$ gemäß Gleichung (11).

$$R_{xx}(m) = \frac{1}{N}\cdot\sum_{n=0}^{+\infty} x(n)\cdot x(n+m) \quad \text{für} \quad m = 0,1,...,N-1 \qquad (11)$$

Als Signal $x(n)$ kann entweder der Betrag $|x_{BB}(n)|$ des Empfangssignals im Basisband $x_{BB}(n)$ oder die Phase $\arg\{x_{BB}(n)\}$ des Empfangssignals im Basisband $x_{BB}(n)$ zu den diskreten Abtastzeitpunkten $n$ verwendet werden.

8

Anschließend erfolgt in der ersten Ausführungsform der Erfindung die Ermittlung der Werte des Leistungsdichtespektrums $\Gamma_x(\omega)$ an den einzelnen Differenzfrequenzen $\Delta\omega_i$ gemäß Gleichung (12). Die Ermittlung des Leistungsdichtespektrums $\Gamma_x(\omega)$ erfolgt gemäß dem Satz von Wiener-Khintchine aus der diskreten Fourier-Transformation der Autokorrelationsfunktion $R_{xx}(m)$.

$$\Gamma_x(\omega) = \sum_{m=-N+1}^{N-1} R_{xx}(m) \cdot e^{-j\omega m} \qquad (12)$$

In der zweiten Ausführungsform der Erfindung erfolgt die Ermittlung der Werte des Leistungsdichtespektrums $\Gamma_x(\omega)$ an den einzelnen Differenzfrequenzen $\Delta\omega_i$ gemäß Gleichung (13) aus der diskreten Fourier-Transformation und anschließenden Betragsbildung der Funktion $x(n)$, für die entweder der Betrag $|x_{BB}(n)|$ des Empfangssignals im Basisband $x_{BB}(n)$ und/oder die Phase $\arg\{x_{BB}(n)\}$ des Empfangssignals im Basisband $x_{BB}(n)$ zu den diskreten Abtastzeitpunkten $n$ verwendet wird.

$$\Gamma_x(\omega) = \left| \sum_{n=-N+1}^{N-1} x(n) \cdot e^{-j\omega n} \right|^2 \qquad (13)$$

Für den Fall, dass die Differenzfrequenzen im Empfangssignal aufgrund des Dopplereffekts und/oder aufgrund von Frequenzschwankungen der im Sender und/oder Empfänger verwendeten Oszillatoren einer Frequenzschwankung unterworfen sind, kommt es zu einer Verbreiterung der Spektrallinie im Leistungsdichtespektrum an der mit einer Frequenzschwankung überlagerten Differenzfrequenz, wie im Folgenden gezeigt wird:

Da die Autokorrelationsfunktion $R_{xx}(m)$ eine gerade Funktion darstellt, wird für die weitere Herleitung einzig der Kosinus-Term des komplexen Exponentialterms in der mathematischen Beziehung für das Leistungsdichtespektrum $\Gamma_x(\omega_k)$ bei der Differenzfrequenz $\omega_k$ in Gleichung (12) berücksichtigt.

$$\Gamma_x(\omega_k) = \sum_{m=-N+1}^{N-1} R_{xx}(m) \cdot \cos(\omega_k \cdot n) \qquad (14)$$

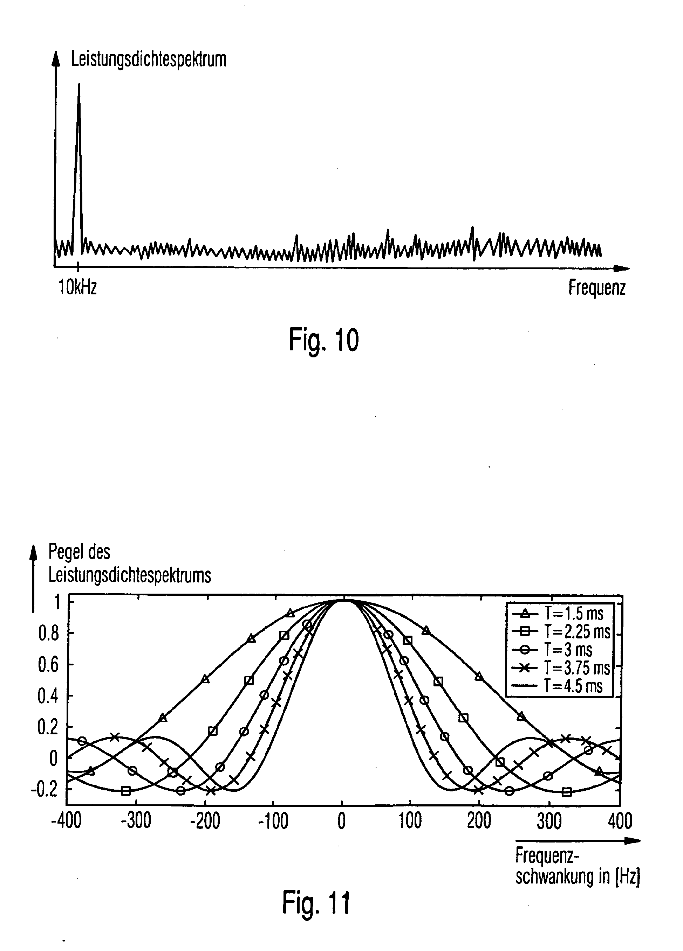

Ein optimaler Wert für das Leistungsdichtespektrum $\Gamma_x(\omega_k)$ ergibt sich, wenn die Autokorrelationsfunktion $R_{xx}(m)$ auch eine Kosinus-Funktion bei der Frequenz $\omega_k \cdot n$ darstellt. Bei einer Frequenzschwankung $\Delta\omega$ der Differenzfrequenz $\omega_k$ verschlechtert sich der Wert des Leistungsdichtespektrums $\Gamma_x(\omega_k + \Delta\omega)$. Zur Untersuchung der Auswirkung einer Frequenzschwankung $\Delta\omega$ der Differenzfrequenz $\omega_k$ auf das Leistungsdichtespektrum $\Gamma_x(\omega_k + \Delta\omega)$ wird die diskrete mathematische Beziehung für das Leistungsdichtespektrum $\Gamma_x(\omega_k)$ in eine kontinuierliche mathematische Beziehung für das Leistungsdichtespektrum $\Gamma_x(\omega_k + \Delta\omega)$ gemäß Gleichung (15) übergeführt, in der $T$ die Dauer der Autokorrelationssequenz ist. Die Auflösung des Integrals in Gleichung (15) führt zur Si-Funktion, die in Abhängigkeit der Frequenzschwankung $\Delta\omega$ und für unterschiedliche Längen $T$ der Autokorrelationssequenz in Fig. 11 dargestellt ist.

$$\Gamma_x(\omega_k + \Delta\omega_k) = \frac{2}{T} \cdot \int_{\tau=0}^{T} \cos(\omega_k \cdot \tau) \cdot \cos((\omega_k + \Delta\omega) \cdot \tau) d\tau = \qquad (15)$$

$$= \frac{1}{T} \cdot \int_{\tau=0}^{T} \cos(\Delta\omega \cdot \tau) d\tau + \frac{1}{T} \cdot \int_{\tau=0}^{T} \cos(2 \cdot \omega_k + \Delta\omega \cdot \tau) d\tau =$$

$$= \frac{1}{\Delta\omega \cdot T} \cdot \sin(\Delta\omega \cdot T) + \underbrace{\frac{1}{(2 \cdot \omega_k + \Delta\omega) \cdot T}}_{\rightarrow 0 \; f\ddot{u}r \omega_k \gg \Delta\omega} \cdot \sin((2 \cdot \omega_k + \Delta\omega) \cdot T) =$$

$$= si(\Delta\omega \cdot T)$$

Wie aus Gleichung (15) sowie Fig. 11 hervorgeht, verschlechtert sich mit zunehmender Länge $T$ der Autokorrelationssequenz die zulässige Bandbreite $\Delta B$ für Frequenzschwankungen $\Delta\omega$ um die jeweilige Differenzfrequenz $\omega_k$, während gleichzeitig die Frequenzselektivität bei der Erfassung einer Spektrallinie des Leistungsdichtspektrums $\Gamma_x(\omega_k)$ mit zunehmender Länge $T$ der Autokorrelationssequenz zunimmt.

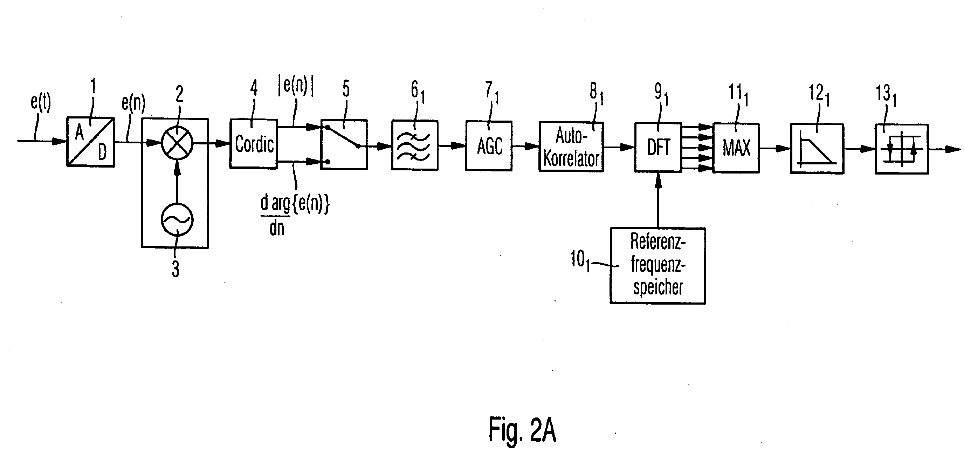

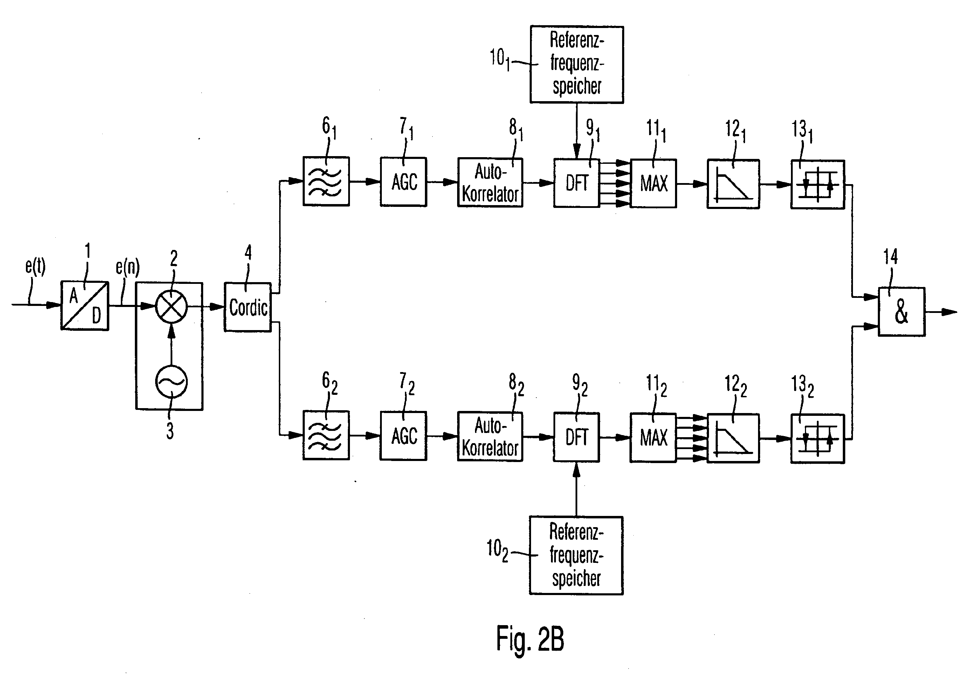

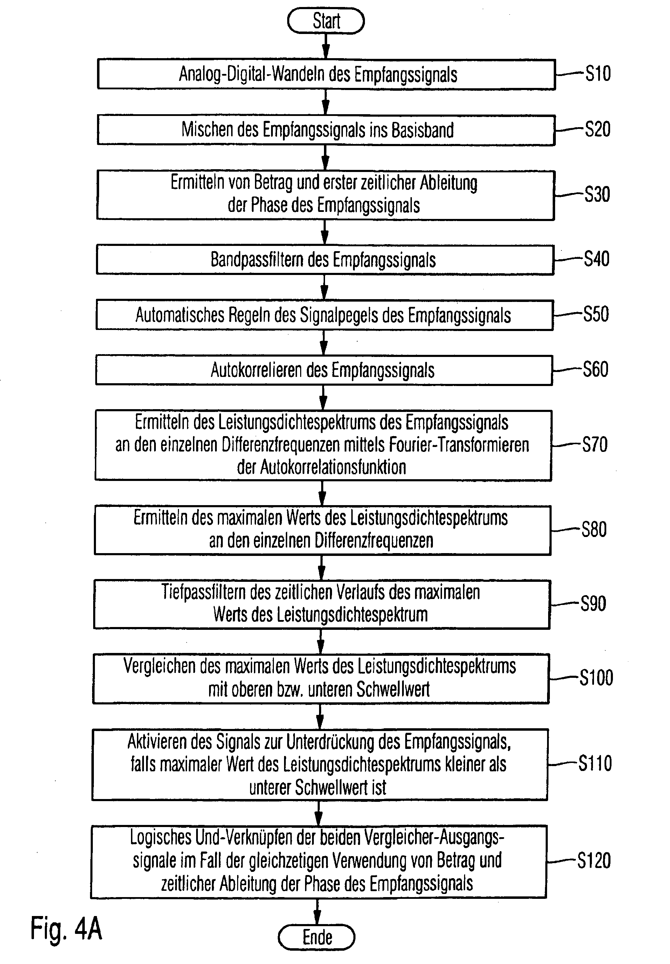

Im Folgenden wird die erste Ausführungsform des erfindungsgemäßen Verfahrens zur Erzeugung eines Signals zur Unterdrückung eines Empfangssignals in den Ausprägungen der ersten Untervariante der ersten und zweiten Variante der Erfindung anhand des Flussdiagramms in Fig. 4A erläutert. Hierzu werden auch die erste und zweite Variante der ersten Ausführungsform der erfindungsgemäßen Vorrichtung zur Erzeugung eines Signals zur Unterdrückung eines Empfangssignals anhand des Blockdiagramms in Fig. 2A und 2B beschrieben.

Im ersten Verfahrensschritt S10 wird das analoge Empfangssignal $e(t)$, das gemäß Fig. 5 beispielsweise aus zwei periodischen Nutzsignalen und einem überlagerten Rauschsignalanteil besteht, in einem Analog-Digital-Wandler 1 in ein korrespondierendes digitales Empfangssignal $e(n)$ umgesetzt.

Im nächsten Verfahrensschritt S20 erfolgt in einem Mischer 2 das Abwärtsmischen des digitalen Empfangssignals $e(n)$ vom Zwischenfrequenzband ins Basisband. Der Mischer 2 wird hierzu von einem lokalen Oszillator 3 mit dem Zwischenfrequenzträger versorgt.

Alternativ kann die Abwärtsmischung des Empfangssignals in der ersten Ausführungsform wie auch in allen weiteren noch offenbarten Ausführungsformen vor der Analog-DigitalWandlung durchgeführt werden und ist von der Erfindung mit abgedeckt. In diesem Fall ist der Mischer 2 zusammen mit dem lokalen Oszillator 3 vor dem Analog-Digital-Wandler 1 geschaltet.

Die Ermittlung des Betrags $|e(n)|$ und der differentiellen Phase $\frac{d \arg\{e(n)\}}{dn}$ des digitalen Empfangssignals im Basisband mithilfe eines sogenannten CORDIC-Bausteins 4 ist Inhalt des Verfahrensschritts S30.

In der ersten Variante der ersten Ausführungsform der Erfindung wird entweder der Betrag $|e(n)|$ oder die differentielle Phase $\frac{d \arg\{e(n)\}}{dn}$ des digitalen Empfangssignals im Basisband über einen Schalter 5 einem nachfolgenden ersten Bandpassfilter $6_1$ zugeführt. In der zweiten Variante der ersten Ausführungsform der Erfindung wird der Betrag $|e(n)|$ des digitalen Empfangssignals im Basisband einem ersten Bandpassfilter $6_1$ und die differentielle Phase $\frac{d \arg\{e(n)\}}{dn}$ des digitalen Empfangssignals im Basisband einem zweiten Bandpassfilter $6_2$ zugeführt.

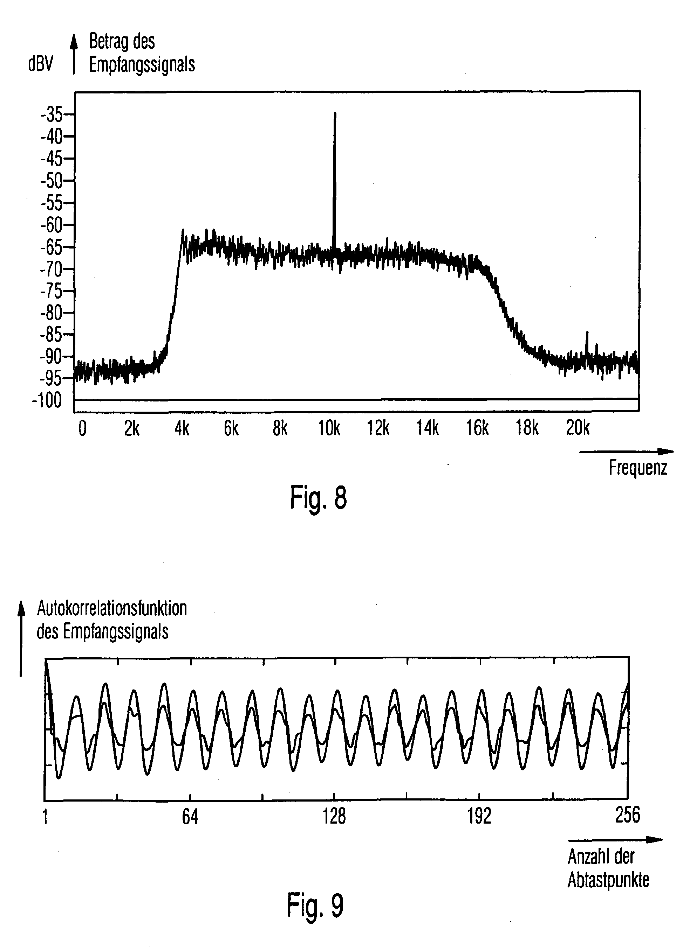

Im ersten und zweiten Bandpassfilter $6_1$ und $6_2$ erfolgt im nächsten Verfahrensschritt S40 eine Bandpassfilterung des jeweiligen Basisbandsignals - Betrag $|e(n)|$ und/oder differentielle Phase $\frac{d \arg\{e(n)\}}{dn}$ des digitalen Empfangssignals $e(n)$ im Basisband - innerhalb des Frequenzbandes, in dem sich die einzelnen Differenzfrequenzen des CLIMAX-Standards befinden. Sämtliche Differenzfrequenzen des aktuellen CLIMAX-Standards befinden sich gemäß der Tabelle in Fig. 1 innerhalb des Frequenzbereiches zwischen 4 kHz und 16 kHz. Von der Erfindung sind natürlich auch andere Frequenzbereiche mit Differenzfrequenzen von zukünftigen CLIMAX-Standards mit abgedeckt. Das Ergebnis der Bandpassfilterung ist im Frequenzdiagramm der Fig. 8 dargestellt, bei dem der bandpassgefilterte Frequenzbereich zwischen 4kHz und 16kHz mit der Nutzsignal-Spektrallinie bei 10 kHz deutlich zu erkennen ist.

Im nächsten Verfahrensschritt S50 erfolgt eine automatische Pegelregelung des jeweiligen gefilterten Basisbandsignals - gefilterter Signalverlauf des Betrags $|e(n)|$ und/oder der differentiellen Phase $\dfrac{d\arg\{e(n)\}}{dn}$ des digitalen Empfangssignals - in einer ersten und/oder zweiten Funktionseinheit zur automatischen Pegelregelung des Empfangssignals $7_1$ bzw. $7_2$. Bei der automatischen Pegelregelung erfolgt eine Normierung des jeweiligen Basisbandsignals $x(n)$ mit dem zugehörigen Effektivwert - Root-Mean-Square(RMS)-Wert - gemäß Gleichung (16).

$$\bar{x}(n) = \frac{x(n)}{\sqrt{E\left\{x(n)^2\right\}}} \tag{16}$$

Die Normierung mit dem zugehörigen RMS-Wert (RMS = Root Mean Square = Wurzel des quadratischen Mittelwerts) ermöglicht eine optimale Anpassung des jeweiligen Basisbandsignals $x(n)$ an den Dynamikbereich der einzelnen Verarbeitungsstufen in der Signalverarbeitungskette, indem einerseits der vorhandene Dynamikbereich der einzelnen Verarbeitungsstufen in der Signalverarbeitungskette bestmöglich verwendet wird und andererseits ein Überlauf (Overflow) in den einzelnen Verarbeitungsstufen in der Signalverarbeitungskette verhindert wird.

Im darauffolgenden Verfahrensschritt S60 wird das jeweilige gefilterte und hinsichtlich seines Signalpegels normierte Empfangssignal in einem ersten und/oder zweiten Autokorrelator $8_1$ und/oder $8_2$ einer Autokorrelation gemäß Gleichung (11) unterzogen. Das Autokorrelationsergebnis ist in Fig. 9 dargestellt. Zu erkennen ist die Periodizität (12,8 Abtastwerte pro Periode) der Spektrallinie bei der Differenzfrequenz in Höhe von 10 kHz in der Autokorrelationsfunktion $R_{xx}(m)$ sowie das nach der Bandpassfilterung noch vorhandene Restrauschen und der für eine Autokorrelationsfunktion typische Maximalwert beim Zeitpunkt Null.

Im nächsten Verfahrensschritt werden die Werte des Leistungsdichtespektrums $\Gamma_x(\omega)$ des gefilterten und hinsichtlich seines Signalpegels angepassten Empfangssignals an den einzelnen Differenzfrequenzen des verwendeten CLIMAX-Standards ermittelt. Hierzu wird gemäß Gleichung (12) entsprechend dem Satz von Wiener-Khintchine das Leistungsdichtespektrum $\Gamma_x(\omega)$ des Empfangssignals durch Fourier-Transformieren der Autokorrelationsfunktion des Empfangssignals in einem ersten und/oder zweiten diskreten Fourier-Transformator $9_1$ und/oder $9_2$ ermittelt. Die Differenzfrequenzen, die jeweils in einem ersten und/oder zweiten Referenzfrequenzspeicher $10_1$ und/oder $10_2$ abgespeichert sind, ergeben sich aus den Differenzen zwischen allen Trägerfrequenzen bei verwendeter Frequenzträgerbandbreite und verwendeter Anzahl von Frequenzträgern. Bei beispielsweise 25 kHz Frequenzträgerbandbreite und insgesamt 5 Frequenzträgern ergeben sich gemäß der Tabelle in Fig. 1 folgende Differenzfrequenzen: 4 kHz, 8 kHz, 12 kHz und 16 kHz. Aus Fig. 10 ist das Leistungsdichtespektrum $\Gamma_x(\omega)$ des Empfangssignals dargestellt. Deutlich zu erkennen ist die Nutzsignal-Spektrallinie bei der Differenzfrequenz in Höhe von 10 kHz, die gegenüber den benachbarten Rauschsignalpegeln mit einer hohen Frequenzselektivität detektierbar ist.

Im nächsten Verfahrensschritt S80 wird von allen bei den einzelnen Differenzfrequenzen jeweils detektierten Werten des Leistungsdichtespektrums $\Gamma_x(\omega)$ des Empfangssignals in einem ersten und/oder zweiten Maximalwertdetektor $11_1$ und/oder $11_2$ der jeweils größte Wert des Leistungsdichtespektrums $\Gamma_x(\omega)$ des Empfangssignals ermittelt.

Da die Werte des Leistungsdichtespektrums $\Gamma_x(\omega)$ des Empfangssignals bei den einzelnen Differenzfrequenzen quasikontinuierlich ermittelt werden, weist auch der in Verfahrensschritt S80 ermittelte größte Wert des Leistungsdichtespektrums $\Gamma_x(\omega)$ des Empfangssignals einen quasikontinuierlichen Zeitverlauf auf. Um ein ständiges Schalten am Ausgang eines nachfolgenden ersten und/oder zweiten Vergleichers $13_1$ und/oder $13_2$ - so genannter "Schnattervorgang" - zu verhindern, wird der quasikontinuierliche Verlauf des größten Wertes des Leistungsdichtespektrums $\Gamma_x(\omega)$ des Empfangssignals im nächsten Verfahrensschritt S90 über ein erstes und/oder zweites Tiefpassfilter $12_1$ und/oder $12_2$ zur Signalglättung tiefpassgefiltert.

Im darauffolgenden Verfahrensschritt S100 wird der jeweilige tiefpassgefilterte Verlauf des größten Wertes des Leistungsdichtespektrums $\Gamma_x(\omega)$ des Empfangssignals in einem ersten und/oder zweiten Vergleicher $13_1$ und/oder $13_2$ mit einem ersten und/oder zweiten Schwellwert verglichen.

Die Verwendung eines typischerweise unterschiedlichen ersten und zweiten Schwellwerts im ersten und zweiten Vergleicher $13_1$ und/oder $13_2$ ist in der Tatsache begründet, dass das Pegelniveau des Leistungsdichtespektrums $\Gamma_x(\omega)$ zwischen dem Betrag $|e(n)|$ und der Phase $\arg\{e(n)\}$ des digitalen Empfangssignals im Basisband in der Regel unterschiedlich ist und durch die Verwendung eines unterschiedlichen und jeweils angepassten ersten und zweiten Schwellwerts die Aktivierung bzw. Deaktivierung des Signals zur Unterdrückung des Empfangssignals zwischen dem ersten und zweiten Vergleicher $13_1$ und $13_2$ im ersten und zweiten Signalpfad angeglichen wird.

Zusätzlich zur Signalglättung im ersten und/oder zweiten Tiefpassfilter $12_1$ und/oder $12_2$ wird zur Vermeidung eines "Schnattervorgangs" im ersten und zweiten Vergleicher $13_1$ und $13_2$ jeweils eine Hysterese mit einem ersten und zweiten oberen Schwellwert zur Deaktivierung des Signals zur Unterdrückung des Empfangssignals und mit einem ersten und zweiten unteren Schwellwert zur Aktivierung des Signals zur Unterdrückung des Empfangssignals implementiert.

Im nächsten Verfahrensschritt S110 wird am Ausgang des ersten bzw. zweiten Vergleichers $13_1$ bzw. $13_2$ jeweils das Signal zur Unterdrückung des Empfangssignals, das so genannte Squelch-Signal aktiviert, falls der tiefpassgefilterte Verlauf des größten Wertes des Leistungsdichtespektrums $\Gamma_x(\omega)$ des Empfangssignals den unteren ersten bzw. zweiten Schwellwert unterschreitet. Äquivalent wird am Ausgang des ersten bzw. zweiten Vergleichers $13_1$ bzw. $13_2$ jeweils das Signal zur Unterdrückung des Empfangssignals, das so genannte Squelch-Signal, deaktiviert, falls der tiefpassgefilterte Verlauf des größten Wertes des Leistungsdichtespektrums $\Gamma_x(\omega)$ des Empfangssignals den oberen ersten bzw. zweiten Schwellwert überschreitet.

Im abschließenden Verfahrensschritt S120, der einzig in der zweiten Variante der ersten Ausführungsform der Erfindung Anwendung findet, werden die beiden Ausgangssignale des ersten und zweiten Vergleichers $13_1$ und $13_2$ bzw. des ersten und zweiten Signalpfades über ein UND-Gatter 14 zur Erzeugung des eigentlichen Signals zur Unterdrückung des Empfangssignals logisch UND-verknüpft.

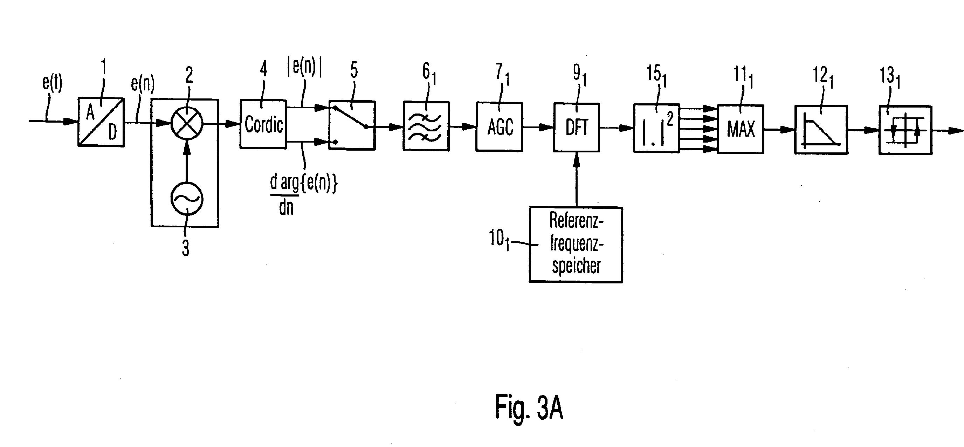

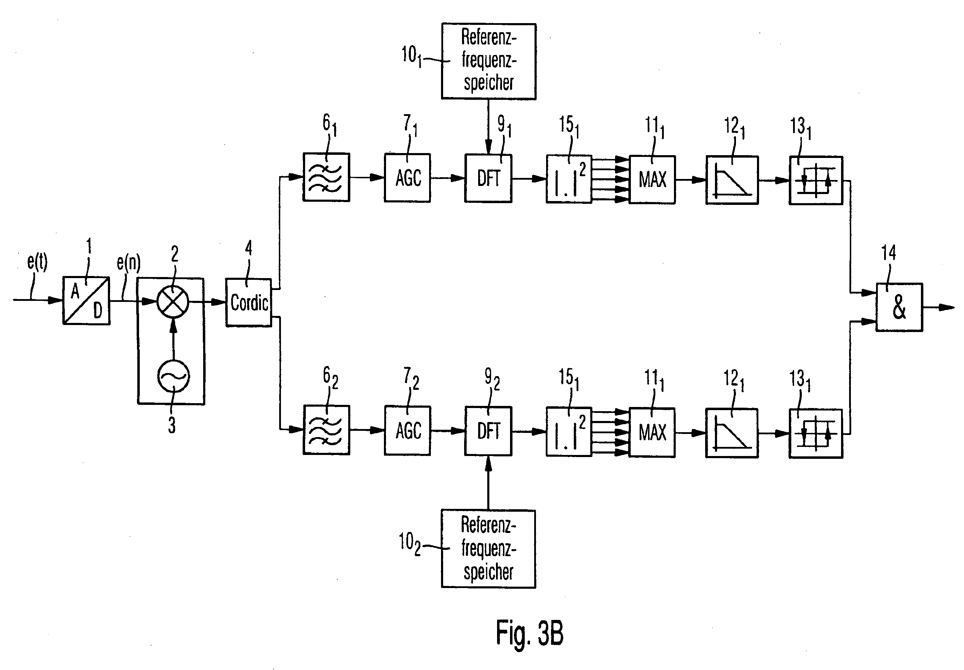

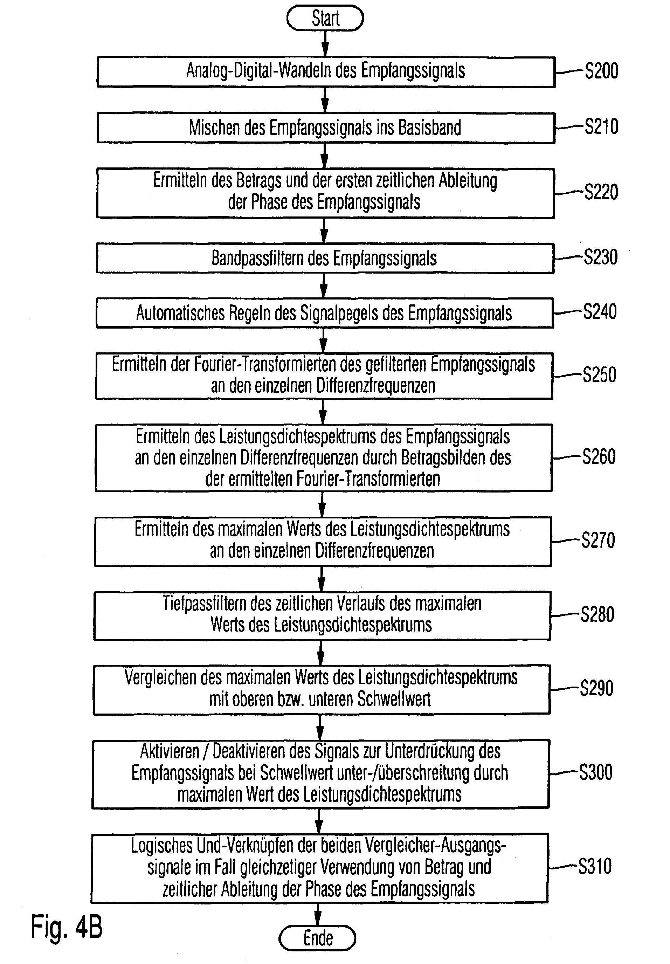

Im Folgenden wird die zweite Ausführungsform des erfindungsgemäßen Verfahrens zur Erzeugung eines Signals zur Unterdrückung eines Empfangssignals anhand des Flussdiagramms in den Ausprägungen der ersten Untervariante der ersten und zweiten Variante der Erfindung in Fig. 4B erläutert. Hierzu werden auch die erste und zweite Variante der zweiten Ausführungsform der erfindungsgemäßen Vorrichtung zur Erzeugung eines Signals zur Unterdrückung eines Empfangssignals anhand des Blockdiagramms in Fig. 3A und 3B beschrieben.

Die Verfahrensschritte S200, S210, S220, S230, S240, S270, S280, S290, S300 und S310 der zweiten Ausführungsform des erfindungsgemäßen Verfahrens zur Erzeugung eines Signals zur Unterdrückung eines Empfangssignals entsprechen den Verfahrensschritten S10, S20, S30, S40, S50, S80, S90, S100, S110 und S120 der ersten Ausführungsform des erfindungsgemäßen Verfahrens zur Erzeugung eines Signals zur Unterdrückung eines Empfangssignals und werden im Folgenden nicht mehr beschrieben. Auch die zugehörigen Funktionseinheiten 1, 2, 3, 4, 5, $6_1$, $6_2$, $7_1$, $7_2$, $9_1$, $9_2$, $10_1$, $10_2$, $11_1$, $11_2$, $12_1$, $12_2$, $13_1$, $13_2$, 14 in der ersten und zweiten Variante der zweiten Ausführungsform der erfindungsgemäßen Vorrichtung zur Erzeugung eines Signals zur Unterdrückung eines Empfangssignals entsprechen den zugehörigen Funktionseinheiten 1, 2, 3, 4, 5, $6_1$, $6_2$, $7_1$, $7_2$, $9_1$, $9_2$, $10_1$, $10_2$, $11_1$, $11_2$, $12_1$, $12_2$, $13_1$, $13_2$, 14 in der ersten und zweiten Variante der zweiten Ausführungsform der erfindungsgemäßen Vorrichtung zur Erzeugung eines Signals zur Unterdrückung eines Empfangssignals und werden im Folgenden auch nicht mehr besprochen.

In der zweiten Ausführungsform der Erfindung wird in Verfahrensschritt S250 die jeweilige Fourier-Transformierte des gefilterten und hinsichtlich seines Signalpegels geregelten Empfangssignals an den einzelnen Differenzfrequenzen im ersten und/oder zweiten diskreten Fourier-Transformator $9_1$ und/oder $9_2$ ermittelt. Der erste und/oder zweite diskrete Fourier-Transformator $9_1$ und/oder $9_2$ erhält die einzelnen Differenzfrequenzen jeweils von einem Referenzfrequenzspeicher $10_1$ und/oder $10_2$.

Im darauffolgenden Verfahrensschritt S260 erfolgt durch Betragsbildung der an den einzelnen Differenzfrequenzen jeweils ermittelten Fourier-Transformierten des gefilterten und hinsichtlich seines Signalpegels geregelten Empfangssignals im ersten und/oder zweiten Betragsbildner $15_1$ und/oder $15_2$ die Bestimmung des Leistungsdichtespektrums $\Gamma_x(\omega)$ des Empfangssignals gemäß Gleichung (13).

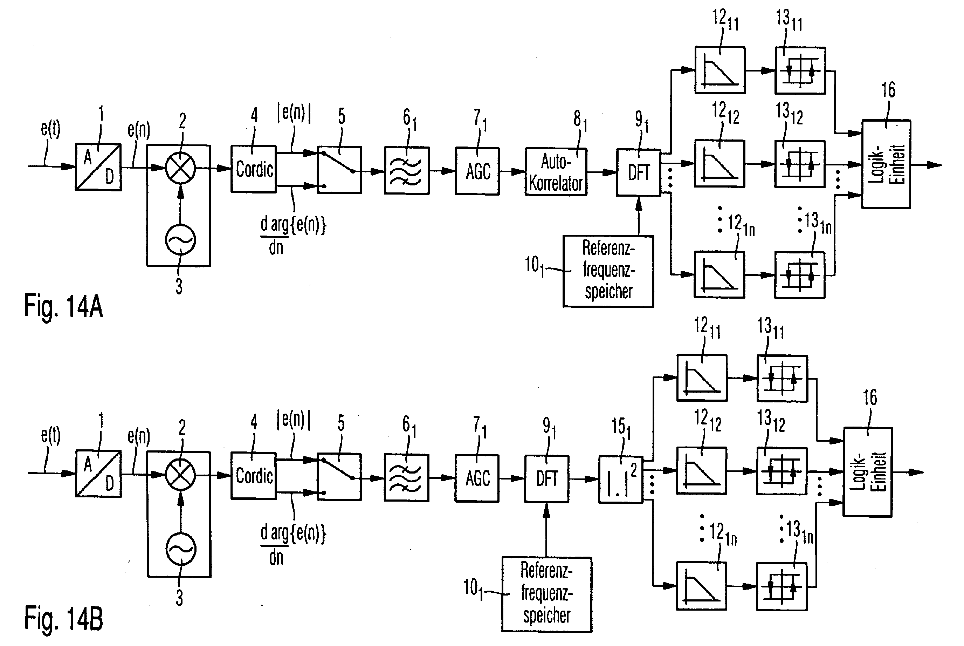

Während in der bisher dargestellten ersten Untervariante der einzelnen Varianten und Ausführungsformen der Erfindung die Aktivierung bzw. Deaktivierung des Signals zur Unterdrückung des Empfangssignals auf der Basis einer einzigen Spektrallinie im Leistungsdichtespektrum ermittelt wird, nämlich der Spektrallinie im Leistungsdichtespektrum mit dem besten Empfang im Empfänger und somit mit dem höchsten Pegelwert, erfolgt die Aktivierung bzw. Deaktivierung des Signals zur Unterdrückung des Empfangssignals in einer zweiten und dritten Untervariante der Erfindung, die in den Figuren 14A und 14B dargestellt ist, erst bei Vorliegen von mehreren, jeweils vorher festgelegten Spektrallinien des Leistungsdichtespektrums mit jeweils einem Mindestpegelwert.

Hierbei handelt es sich in der zweiten Untervariante der Erfindung um Spektrallinien des Leistungsdichtespektrums bei mehreren definierten Differenzfrequenzen im Grundwellenbereich oder in der dritten Untervariante der Erfindung um Spektrallinien des Leistungsdichtespektrums im Grund- und gleichzeitig im Oberwellenbereich, die alle jeweils einen Pegelwert oberhalb eines vorher festgelegten Mindestpegelwerts aufweisen. Im Fall der Berücksichtigung von Spektrallinien des Leistungsdichtespektrums bei mehreren Differenzfrequenzen im Grund- und gleichzeitig im Oberwellenbereich ist die obere Grenzfrequenz des ersten und/oder zweiten Bandpassfilters $6_1$ und/oder $6_2$ entsprechend in den Oberwellenbereich zu verschieben.

Anstelle eines ersten und/oder zweiten Maximalwertdetektors $11_1$ und/oder $11_2$, wie in den Figuren 2A, 2B, 3A und 3B dargestellt ist, sind in der zweiten und dritten Untervariante der Erfindung, wie in Fig. 14A für die erste Variante der ersten Ausführungsform der Erfindung und in Fig. 14B für die erste Variante der zweiten Ausführungsform der Erfindung dargestellt ist, eine der Anzahl von Differenzfrequenzen im Grund- und Oberwellenbereich gemäß dem CLIMAX-Standard entsprechende Anzahl n von Signalpfaden mit jeweils einem Tiefpassfilter $12_{11}$, $12_{12}$,..., $12_{1n}$ und jeweils einem Vergleicher $13_{11}$, $13_{12}$,..., $13_{1n}$ vorgesehen.

Auf diese Weise wird für die Spektrallinie des Leistungsdichtespektrums an jeder der betrachteten Differenzfrequenzen im Grund- und Oberwellenbereich ein Signal am Ausgang des jeweiligen Vergleichers $13_{11}$, $13_{12}$,..., $13_{1n}$ in Abhängigkeit des Pegelwertes der Spektrallinie relativ zum unteren bzw. oberen Schwellwert aktiviert bzw. deaktiviert. Über eine Logik-Einheit 16, die mit den Ausgängen der einzelnen Vergleicher $13_{11}$, $13_{12}$,..., $13_{1n}$ verbunden ist, können zur Aktivierung bzw. Deaktivierung des Signals zur Unterdrückung des Empfangssignals die einzelnen Ausgangssignale der Vergleicher $13_{11}$, $13_{12}$,..., $13_{1n}$ logisch, bevorzugt logisch UND, miteinander verknüpft werden und damit die Differenzfrequenzen im Grund- und/oder Oberwellenbereich ausgewählt werden, an denen die zur Erzeugung des Signals zur Unterdrückung des Empfangssignals verwendeten Werte des Leistungsdichtespektrums liegen.

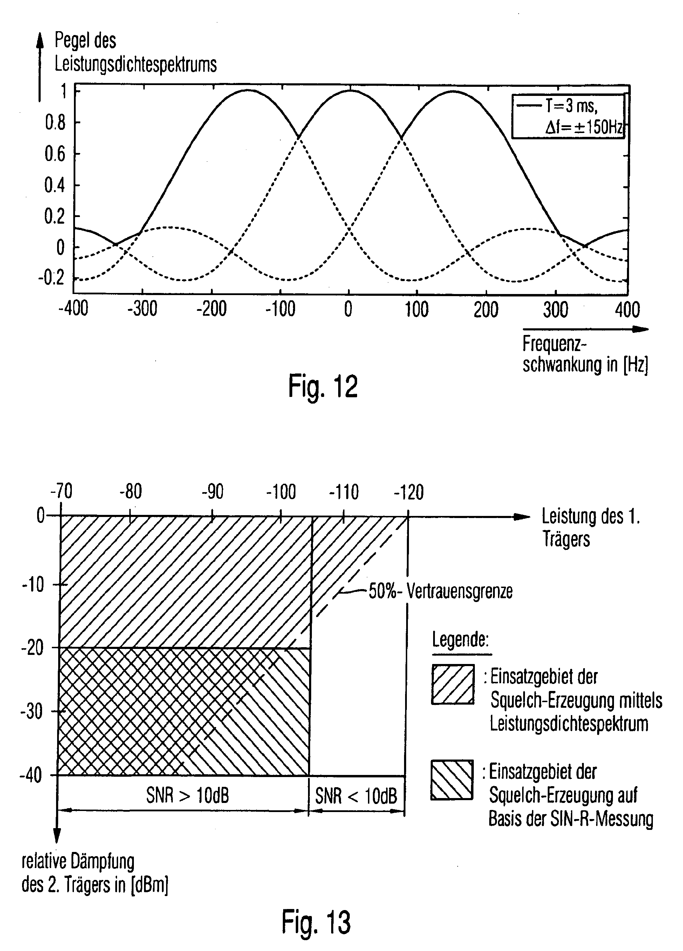

Zur Erhöhung der Bandbreite $\Delta B$ bei auftretender Frequenzschwankung $\Delta\omega$ gemäß Gleichung (15) und Fig. 11 wird nicht nur der Wert des Leistungsdichtespektrums $\Gamma_x(\omega)$ bei der Differenzfrequenz $\omega_k$, sondern auch, wie in Fig. 12 dargestellt ist, bei benachbarten Frequenzen $\omega_k \pm \Delta\omega$ ermittelt.

Aus Fig. 13 ist der Anwendungsbereich der erfindungsgemäßen Squelch-Signal-Erzeugung auf der Basis der Messung des Leistungsdichtespektrums im Vergleich zur Squelch-Signal-Erzeugung auf der Basis einer Signal-Rausch-Abstands-Messung in Abhängigkeit der Leistung eines ersten Nutzsignalträgers und der relativen Dämpfung des zweiten Nutzsignalträgers gegenüber dem ersten Nutzsignalträger in einen CLIMAX-Betrieb dargestellt.

Die Squelch-Signal-Erzeugung auf der Basis einer Signal-Rausch-Abstands-Messung nach dem Stand der Technik ist auf den Anwendungsbereich beschränkt, in dem ein hoher Leistungspegel eines Nutzsignalträgers vorliegt. Man beachte in Fig. 13 die vergleichsweise hohe Leistung des ersten Nutzsignalträgers zwischen -70 dBm und -115 dBm mit einem Signal-Rausch-Abstand größer als 10 dB und die vergleichsweise geringe relative Dämpfung des zweiten Nutzsignalträgers zum ersten Nutzsignalträger zwischen -20 dBm und -40 dBm.

Die erfindungsgemäße Squelch-Signal-Erzeugung auf der Basis der Messung des Leistungsdichtespektrums ist dagegen auf den wesentlich größeren Anwendungsbereich oberhalb einer bestimmten Vertrauensgrenze beschränkt. In Fig. 13 ist der Anwendungsbereich oberhalb der gestrichelt dargestellten 50%-Vertrauensgrenze dargestellt. Neben der typischerweise verwendeten 50%-Vertrauensgrenze können natürlich auch andere Werte für die Vertrauensgrenze benutzt werden.

Die Erfindung ist nicht auf die dargestellten Ausführungsformen, Varianten und Untervarianten beschränkt. Von der Erfindung sind alle Kombinationen der offenbarten Ausführungsformen, Varianten und Untervarianten, insbesondere eine Kombination der in Fig. 14A bzw. 14B dargestellten Untervarianten der ersten Variante der ersten und zweiten Ausführungsform mit der in Fig. 2B bzw. Fig. 3B dargestellten zweiten Variante der ersten und zweiten Ausführungsform, abgedeckt.

**Patentansprüche**

1. Verfahren zum Aktivieren bzw. Deaktivieren eines Signals zur Unterdrückung eines Empfangssignals, das aus der Überlagerung von mehreren von jeweils einem Sender gesendeten und in der Frequenz unterschiedlichen Signalen und einem Rauschen besteht, mittels Bandpassfiltern des Empfangssignals (S40;S230),

   **dadurch gekennzeichnet,**

   **dass** zusätzlich folgende Verfahrensschritte durchgeführt werden:

   Ermitteln von Werten eines Leistungsdichtespektrums des gefilterten Empfangssignals bei jeder Differenzfrequenz (S70;S260), die sich jeweils aus der Differenz zwischen jeweils zwei zu jeweils einem Sender gehörigen Frequenzen ergibt,

   Vergleichen der Werte des Leistungsdichtespektrums an den Differenzfrequenzen mit einem Schwellwert (S100;S290) und Aktivieren des Signals zur Unterdrückung des Empfangssignals bei Unterschreiten des Schwellwerts durch den maximalen Wert des Leistungsdichtespektrums und Deaktivieren des Signals zur Unterdrückung des Empfangssignals bei Überschreiten des Schwellwerts durch den maximalen Wert des Leistungsdichtespektrums (S110;S300).

2. Verfahren nach Anspruch 1,
   **dadurch gekennzeichnet,**
   **dass** der größte Wert des Leistungsdichtespektrums an den Differenzfrequenzen ermittelt wird und mit einem Schwellwert verglichen wird.

3. Verfahren nach Anspruch 1 oder 2,
   **dadurch gekennzeichnet,**

**dass** die Werte des Leistungsdichtespektrums an ausgewählten Differenzfrequenzen in einem Grundwellenbereich ermittelt werden und mit jeweils einem Schwellwert verglichen werden.

4. Verfahren nach Anspruch 1 oder 2,
   **dadurch gekennzeichnet,**
   **dass** die Werte des Leistungsdichtespektrums an ausgewählten Differenzfrequenzen in einem Grundwellenbereich und in einem Oberwellenbereich ermittelt werden und mit jeweils einem Schwellwert verglichen werden.

5. Verfahren nach einem der Ansprüche 1 bis 4,
   **dadurch gekennzeichnet,**
   **dass** ein endgültiges Signal zur Unterdrückung des Empfangssignals durch logische Verknüpfung der an den Ausgängen mehrerer Vergleicher jeweils erzeugten Signale zur Unterdrückung des Empfangssignals (S120;S310) generiert wird.

6. Verfahren nach einem der Ansprüche 1 bis 5,
   **dadurch gekennzeichnet,**
   **dass** die Ermittlung des Leistungsdichtespektrums des gefilterten Empfangssignals folgende Verfahrensschritte umfasst:

   • Autokorrelieren des gefilterten Empfangssignals (S60) und
   • Ermitteln einer Fourier-Transformierten des autokorrelierten Empfangssignals (S70).

7. Verfahren nach einem der Ansprüche 1 bis 5,
   **dadurch gekennzeichnet,**
   **dass** die Ermittlung des Leistungsdichtespektrums des gefilterten Empfangssignals folgende Verfahrensschritte umfasst:

   • Ermitteln einer Fourier-Transformierten des gefilterten Empfangssignals (S250) und
   • Betragsbilden der ermittelten Fourier-Transformierten (S260).

8. Verfahren zur nach einem der Ansprüche 1 bis 7,
   **dadurch gekennzeichnet,**
   **dass** von dem Empfangssignal der Betrag des Empfangssignals verwendet wird.

9. Verfahren nach einem der Ansprüche 1 bis 8,
   **dadurch gekennzeichnet,**
   **dass** von dem Empfangssignal die erste zeitliche Ableitung der Phase des Empfangssignals verwendet wird.

10. Verfahren nach einem der Ansprüche 1 bis 7,
    **dadurch gekennzeichnet,**
    **dass** für das Empfangssignal gleichzeitig und getrennt voneinander der Betrag und die erste zeitliche Ableitung der Phase des Empfangssignals verwendet werden.

11. Verfahren nach Anspruch 10,
    **dadurch gekennzeichnet,**
    **dass** das Signal zur Unterdrückung des Empfangssignals in einem Signalpfad, in dem der Wert des Leistungsdichtespektrums des Betrags des gefilterten Empfangssignals mit einem ersten Schwellwert verglichen wird, mit dem Signal zur Unterdrückung des Empfangssignals in einem Signalpfad, in dem der Wert des Leistungsdichtespektrums der ersten zeitlichen Ableitung der Phase des gefilterten Empfangssignals mit einem zweiten Schwellwert verglichen wird, zur Erzeugung eines endgültigen Signals zur Unterdrückung des Empfangssignals logisch UND-verknüpft wird.

12. Verfahren nach einem der Ansprüche 1 bis 11,
    **dadurch gekennzeichnet,**
    **dass** zwischen dem Filtern und dem Ermitteln des Leistungsdichtespektrums des Empfangssignals ein automatisches Pegelanpassen des Empfangssignals (S50;S240) durchgeführt wird.

13. Verfahren nach einem der Ansprüche 1 bis 12,
    **dadurch gekennzeichnet,**

**dass** die untere und obere Grenzfrequenz der Bandpassfilterung die kleinste und größte Differenzfrequenz ist.

14. Verfahren nach einem der Ansprüche 1 bis 13,
**dadurch gekennzeichnet,**
**dass** die einzelnen Frequenzen der gesendeten Signale den Spezifikationen des CLIMAX-Standards entsprechen.

15. Verfahren nach einem der Ansprüche 1 bis 14,
**dadurch gekennzeichnet,**
**dass** zum Aktivieren des Signals zur Unterdrückung des Empfangssignals ein unterer Schwellwert bzw. unterer erster Schwellwert bzw. unterer zweiter Schwellwert und zum Deaktivieren des Signals zur Unterdrückung des Empfangssignals ein oberer Schwellwert bzw. oberer erster Schwellwert bzw. oberer zweiter Schwellwert verwendet wird.

16. Verfahren nach einem der Ansprüche 1 bis 15,
**dadurch gekennzeichnet,**
**dass** vor dem Schwellwertvergleich ein Tiefpassfiltern zur Signalglättung des zeitlichen Verlaufs des Werts des Leistungsdichtespektrums (S90;S280) erfolgt.

17. Verfahren nach einem der Ansprüche 1 bis 16,
**dadurch gekennzeichnet,**
**dass** zur Erhöhung der Frequenzselektivität im Fall von Frequenzschwankungen von im Leistungsdichtespektrum enthaltenen Spektrallinien die Werte des Leistungsdichtespektrums zusätzlich an zu den Differenzfrequenzen jeweils benachbarten Frequenzen ermittelt werden.

18. Vorrichtung zum Aktivieren bzw. Deaktivieren eines Signals zur Unterdrückung eines Empfangssignals, das aus der Überlagerung von mehreren von jeweils einem Sender gesendeten und in der Frequenz unterschiedlichen Signalen und einem Rauschen besteht, mit
mindestens einem Bandpassfilter ($6_1, 6_2$) zum Bandpassfiltern des Empfangssignals,
**gekennzeichnet durch**
mindestens eine Funktionseinheit ($8_1$, $8_2$, $9_1$, $9_2$, $10_1$, $10_2$; $9_1$, $9_2$, $10_1$, $10_2$, $15_1$, $15_2$) zur Bestimmung von Werten eines Leistungsdichtespektrums des gefilterten Empfangssignals bei jeder Differenzfrequenz, die sich aus der Differenz zwischen jeweils zwei zu jeweils einem Sender gehörigen Frequenzen ergibt, und
mindestens einen Vergleicher ($13_1$, $13_2$; $13_{11}$, $13_{12}$, ..., $13_{1n}$) zum Vergleichen der Werte des Leistungsdichtespektrums an jeweils einer Differenzfrequenz mit einem Schwellwert und zum Aktivieren bzw. Deaktivieren des Signals zur Unterdrückung des Empfangssignals in Abhängigkeit des Vergleichsergebnisses.

19. Vorrichtung nach Anspruch 18,
**dadurch gekennzeichnet,**
**dass** vor mindestens einen Vergleicher ($13_1, 13_2$) jeweils ein Maximalwertdetektor ($11_1$, $11_2$) zum Ermitteln des größten Wertes des Leistungsdichtespektrums an den einzelnen Differenzfrequenzen geschaltet ist.

20. Vorrichtung nach Anspruch 18 oder 19,
**dadurch gekennzeichnet,**
**dass** die Funktionseinheit ($8_1$, $8_2$, $9_1$, $9_2$, $10_1$, $10_2$; $9_1$, $9_2$, $10_1$, $10_2$, $15_1$, $15_2$) zur Bestimmung von Werten eines Leistungsdichtespektrums des gefilterten Empfangssignals einen Autokorrelator ($8_1$, $8_2$) zum Autokorrelieren des gefilterten Empfangssignals und einen Fourier-Transformator ($9_1$, $9_2$) zum Fourier-Transformieren des autokorrelierten Empfangssignals umfasst.

21. Vorrichtung nach Anspruch 18 oder 19,
**dadurch gekennzeichnet,**
**dass** die Funktionseinheit ($8_1$, $8_2$, $9_1$, $9_2$, $10_1$, $10_2$; $9_1$, $9_2$, $10_1$, $10_2$, $15_1$, $15_2$) zur Bestimmung von Werten eines Leistungsdichtespektrums des gefilterten Empfangssignals einen Fourier-Transformator ($9_1, 9_2$) zur Ermittlung einer Fourier-Transformierten des gefilterten Empfangssignals und einen Betragsbildner ($15_1$, $15_2$) zum Betragsbilden der Fourier-Transformierten umfasst.

22. Vorrichtung nach einem der Ansprüche 18 bis 21,
**dadurch gekennzeichnet,**
**dass** vor jeden Vergleicher ($13_1$, $13_2$; $13_{11}$, $13_{12}$, ..., $13_{1n}$) jeweils ein Tiefpassfilter ($12_1$, $12_2$; $12_{11}$, $12_{12}$, ..., $12_{1n}$)

zur Signalglättung des zeitlichen Verlaufs des Wertes des Leistungsdichtespektrums geschaltet ist.

23. Vorrichtung nach einem der Ansprüche 18 bis 22,
**dadurch gekennzeichnet,**
**dass** zwischen jedem Bandpassfilter ($6_1, 6_2$) und jeder Funktionseinheit ($8_1$, $8_2$, $9_1$, $9_2$, $10_1$, $10_2$; $9_1$, $9_2$, $10_1$, $10_2$, $15_1$, $15_2$) zur Bestimmung von Werten eines Leistungsdichtespektrums des gefilterten Empfangssignals jeweils eine Funktionseinheit ($7_1$, $7_2$) zur automatischen Pegelanpassung des Empfangssignals zwischengeschaltet ist.

24. Vorrichtung nach einem der Ansprüche 18 bis 23,
**dadurch gekennzeichnet,**
**dass** das Bandpassfilter ($6_1, 6_2$) eine erste Bandpassfiltereinheit ($6_1$) umfasst, der der Betrag oder die erste zeitliche Ableitung der Phase des Empfangssignals zugeführt ist.

25. Vorrichtung nach Anspruch 24,
**dadurch gekennzeichnet,**
**dass** der ersten Bandpassfiltereinheit ($6_1$) in einem ersten Signalpfad zumindest eine erste Funktionseinheit ($7_1$) zur automatischen Pegelanpassung des Empfangssignals, eine erste Funktionseinheit ($8_1$, $9_1$, $10_1$; $9_1$, $10_1$, $15_1$) zur Bestimmung von Werten eines Leistungsdichtespektrums des gefilterten Empfangssignals, ein erstes Tiefpassfilter ($12_1$; $12_{11}$, $12_{12}$, ..., $12_{1n}$) und ein erster Vergleicher ($13_1$; $13_{11}$, $13_{12}$, ..., $13_{1n}$) nachgeschaltet sind.

26. Vorrichtung nach einem der Ansprüche 18 bis 23,
**dadurch gekennzeichnet,**
**dass** die Bandpassfilter ($6_1, 6_2$) ein erstes Bandpassfilter ($6_1$), dem der Betrag des Empfangssignals zugeführt ist, und ein zweites Bandpassfilter ($6_2$) sind, dem die erste zeitliche Ableitung der Phase des Empfangssignals zugeführt ist.

27. Vorrichtung nach Anspruch 26,
**dadurch gekennzeichnet,**
**dass** dem ersten Bandpassfilter ($6_1$) in einem ersten Signalpfad zumindest eine erste Funktionseinheit ($7_1$) zur automatischen Pegelanpassung des Empfangssignals, eine erste Funktionseinheit ($8_1$, $9_1$, $10_1$; $9_1$, $10_1$, $15_1$) zur Bestimmung von Werten eines Leistungsdichtespektrums des gefilterten Empfangssignals, ein erstes Tiefpassfilter ($12_1$; $12_{11}$, $12_{12}$, ..., $12_{1n}$) und ein erster Vergleicher ($13_1$; $13_{11}$, $13_{12}$, ..., $13_{1n}$) nachgeschaltet sind und dass dem zweiten Bandpassfilter ($6_2$) in einem zweiten Signalpfad zumindest eine zweite Funktionseinheit ($7_2$) zur automatischen Pegelanpassung des Empfangssignals, eine zweite Funktionseinheit ($8_2$, $9_2$, $10_2$; $9_2$, $10_2$, $15_2$) zur Bestimmung von Werten eines Leistungsdichtespektrums des gefilterten Empfangssignals, ein zweites Tiefpassfilter ($12_2$) und ein zweiter Vergleicher ($13_2$) nachgeschaltet sind.

28. Vorrichtung nach Anspruch 27,
**dadurch gekennzeichnet,**
**dass** der erste Vergleicher ($13_1$; $13_{11}$, $13_{12}$, ..., $13_{1n}$) gegen einen ersten Schwellwert und der zweite Vergleicher ($13_2$) gegen einen zweiten Schwellwert vergleicht.

29. Vorrichtung nach Anspruch 27 oder 28,
**dadurch gekennzeichnet,**
**dass** bei Vorliegen von mehreren Vergleichern ($13_{11}$, $13_{12}$, ..., $13_{1n}$) im ersten oder zweiten Signalpfad die Vergleicher $13_{11}$, $13_{12}$, ..., $13_{1n}$) des ersten und zweiten Signalpfades jeweils mit einer Logik-Einheit (16) verbunden sind.

30. Vorrichtung nach einem der Ansprüche 27 bis 29,
**dadurch gekennzeichnet,**
**dass** die Signale am Ausgang des ersten und zweiten Signalpfads zu einem UND-Gatter (14) zur Erzeugung des Signals zur Unterdrückung des Empfangssignals geführt sind.

31. Vorrichtung nach Anspruch 24 oder 25,
**dadurch gekennzeichnet,**
**dass** die untere und obere Grenzfrequenz der ersten Bandpassfiltereinheit ($6_1$) oder einer zweiten Bandpassfiltereinheit ($6_2$) jeweils die kleinste und größte Differenzfrequenz ist.

32. Vorrichtung nach einem der Ansprüche 18 bis 31,

**dadurch gekennzeichnet,**

**dass** zum Aktivieren des Signals zur Unterdrückung des Empfangssignals ein erster und/oder zweiter Vergleicher ($13_1$, $13_2$; $13_{11}$, $13_{12}$, ..., $13_{1n}$) einen unteren ersten und/oder zweiten Schwellwert und zum Deaktivieren des Signals zur Unterdrückung des Empfangssignals der erste und/oder zweite Vergleicher ($13_1$, $13_2$; $13_{11}$, $13_{12}$, ..., $13_{1n}$) als Schwellwert einen oberen ersten und/oder zweiten Schwellwert aufweist.

**Claims**

1. Method for activating and deactivating a signal for suppressing a received signal which consists of the superimposition of a plurality of signals transmitted from one transmitter in each case and differing in frequency and a noise, by means of band pass filtering of the received signal (S40; S230),
   **characterised in that**
   in addition the following process steps are carried out:

   determination of values of a power density spectrum of the filtered received signal at every difference frequency (S70; S260) resulting in each case from the difference between in each case two frequencies belonging in each case to one transmitter,
   comparison of the values of the power density spectrum at the difference frequencies with a threshold value (S100; S290) and activation of the signal for suppressing the received signal when the maximum value of the power density spectrum is less than the threshold value and deactivation of the signal for suppressing the received signal when the maximum value of the power density spectrum (S110; S300) is more than the threshold value.

2. Method according to claim 1,
   **characterised in that**
   the greatest value of the power density spectrum is determined at the difference frequencies and compared with a threshold value.

3. Method according to claim 1 or 2,
   **characterised in that**
   the values of the power density spectrum are determined at selected difference frequencies in a fundamental range and compared with a threshold value in each case.

4. Method according to claim 1 or 2,
   **characterised in that**
   the values of the power density spectrum are determined at selected difference frequencies in a fundamental range and in a harmonic range and compared with a threshold value in each case.

5. Method according to one of claims 1 to 4,
   **characterised in that**
   a definitive signal for suppressing the received signal is generated by logical linking of the signals produced in each case at the outputs of a plurality of comparators for suppressing the received signal (S120; S310).

6. Method according to one of claims 1 to 5,
   **characterised in that**
   the determination of the power density spectrum of the filtered received signal comprises the following process steps:

   • auto-correlation of the filtered received signal (S60) and
   • determination of a Fourier transform of the auto-correlated received signal (S70).

7. Method according to one of claims 1 to 5,
   **characterised in that**
   the determination of the power density spectrum of the filtered received signal comprises the following process steps:

   • determination of a Fourier transform of the filtered received signal (S250) and
   • formation of the magnitude of the determined Fourier transform (S260).

**8.** Method according to one of claims 1 to 7,
**characterised in that**
of the received signal the magnitude of the received signal is used.

**9.** Method according to one of claims 1 to 8,
**characterised in that**
of the received signal the first derivative of the phase of the received signal with respect to time is used.

**10.** Method according to one of claims 1 to 7,
**characterised in that**
for the received signal the magnitude and the first derivative of the phase of the received signal with respect to time are used simultaneously and separately from one another.

**11.** Method according to claim 10,
**characterised in that**
the signal for suppressing the received signal in a signal path in which the value of the power density spectrum of the magnitude of the filtered received signal is compared with a first threshold value, is linked logically in an AND operation with the signal for suppressing the received signal in a signal path in which the value of the power density spectrum of the first derivative of the phase of the filtered received signal with respect to time is compared with a second threshold value, to generate a definitive signal for suppressing the received signal.

**12.** Method according to one of claims 1 to 11,
**characterised in that**
an automatic adjustment of the level of the received signal (S50; S240) is carried out between the filtering and the determination of the power density spectrum of the received signal.

**13.** Method according to one of claims 1 to 12,
**characterised in that**
the lower and upper limit frequency of the band pass filtering is the smallest and largest difference frequency.

**14.** Method according to one of claims 1 to 13,
**characterised in that**
the individual frequencies of the transmitted signals meet the specifications of the CLIMAX standard.

**15.** Method according to one of claims 1 to 14,
**characterised in that**
a lower threshold value or lower first threshold value or lower second threshold value is used for activating the signal for suppressing the received signal, and an upper threshold value or upper first threshold value or upper second threshold value is used for deactivating the signal for suppressing the received signal.

**16.** Method according to one of claims 1 to 15,
**characterised in that**
before the threshold value comparison low pass filtering is carried out to smooth the signal for the variation of the value of the power density spectrum (S90; S280) as a function of time.

**17.** Method according to one of claims 1 to 16,
**characterised in that**
to increase the frequency selectivity in the event of fluctuations in the frequency of spectral lines contained in the power density spectrum, the values of the power density spectrum are additionally determined at frequencies in each case neighbouring the difference frequencies.

**18.** Device for activating or deactivating a signal for suppressing a received signal which consists of the superimposition of a plurality of signals transmitted from one transmitter in each case and differing in frequency and a noise, with at least one band pass filter ($6_1$, $6_2$) for band pass filtering of the received signal,
**characterised by**
at least one function unit ($8_1$, $8_2$, $9_1$, $9_2$, $10_1$, $10_2$; $9_1$, $9_2$, $10_1$, $10_2$, $15_1$, $15_2$) for determining values of a power density spectrum of the filtered received signal at every difference frequency resulting from the difference between in each case two frequencies belonging in each case to one transmitter, and

at least one comparator ($13_1$, $13_2$; $13_{11}$, $13_{12}$, ..., $13_{1n}$) for comparing the values of the power density spectrum at in each case one difference frequency with a threshold value and for activating or deactivating the signal for suppressing the received signal depending on the result of the comparison.

19. Device according to claim 18,
    **characterised in that**
    in each case a maximum value detector ($11_1$, $11_2$) is connected before at least one comparator ($13_1$, $13_2$) for determining the greatest value of the power density spectrum at the individual difference frequencies.

20. Device according to claim 18 or 19,
    **characterised in that**
    the function unit ($8_1$, $8_2$, $9_1$, $9_2$, $10_1$, $10_2$; $9_1$, $9_2$, $10_1$, $10_2$, $15_1$, $15_2$) for determining values of a power density spectrum of the filtered received signal comprises an auto-correlator ($8_1$, $8_2$) for auto-correlation of the filtered received signal and a Fourier transformer ($9_1$, $9_2$) for Fourier transformation of the auto-correlated received signal.

21. Device according to claim 18 or 19,
    **characterised in that**
    the function unit ($8_1$, $8_2$, $9_1$, $9_2$, $10_1$, $10_2$; $9_1$, $9_2$, $10_1$, $10_2$, $15_1$, $15_2$) for determining values of a power density spectrum of the filtered received signal comprises a Fourier transformer ($9_1$, $9_2$) for determining a Fourier transform of the filtered received signal and a magnitude former ($15_1$, $15_2$) for forming the magnitude of the Fourier transform.

22. Device according to one of claims 18 to 21,
    **characterised in that**
    in each case a low pass filter ($12_1$, $12_2$; $12_{11}$, $12_{12}$, ..., $12_{1n}$) for smoothing the signal for the variation of the value of the power density spectrum as a function of time is connected before each comparator ($13_1$, $13_2$; $13_{11}$, $13_{12}$, ..., $13_{1n}$).

23. Device according to one of claims 18 to 22,
    **characterised in that**
    in each case a function unit ($7_1$, $7_2$) for automatic adjustment of the level of the received signal is connected between each band pass filter ($6_1$, $6_2$) and each function unit ($8_1$, $8_2$, $9_1$, $9_2$, $10_1$, $10_2$; $9_1$, $9_2$, $10_1$, $10_2$, $15_1$, $15_2$) for determining values of a power density spectrum of the filtered received signal.

24. Device according to one of claims 18 to 23,
    **characterised in that**
    the band pass filter ($6_1$, $6_2$) comprises a first band pass filter unit ($6_1$) to which is fed the magnitude or the first derivative of the phase of the received signal with respect to time.

25. Device according to claim 24,
    **characterised in that**
    at least a first function unit ($7_1$) for automatically adjusting the level of the received signal, a first function unit ($8_1$, $9_1$, $10_1$; $9_1$, $10_1$, $15_1$) for determining values of a power density spectrum of the filtered received signal, a first low pass filter ($12_1$; $12_{11}$, $12_{12}$, ..., $12_{1n}$) and a first comparator ($13_1$; $13_{11}$, $13_{12}$, ..., $13_{1n}$) are connected after the first band pass filter unit ($6_1$) in a first signal path.

26. Device according to one of claims 18 to 23,
    **characterised in that**
    the band pass filters ($6_1$, $6_2$) are a first band pass filter ($6_1$) to which is fed the magnitude of the received signal, and a second band pass filter ($6_2$) to which is fed the first derivative of the phase of the received signal with respect to time.

27. Device according to claim 26,
    **characterised in that**
    at least a first function unit ($7_1$) for automatically adjusting the level of the received signal, a first function unit ($8_1$, $9_1$, $10_1$; $9_1$, $10_1$, $15_1$) for determining values of a power density spectrum of the filtered received signal, a first low pass filter ($12_1$, $12_{11}$, $12_{12}$, ..., $12_{1n}$) and a first comparator ($13_1$, $13_{11}$, $13_{12}$, ..., $13_{1n}$) are connected after the first band pass filter ($6_1$) in a first signal path, and
    **in that** at least a second function unit ($7_2$) for automatically adjusting the level of the received signal, a second function unit ($8_2$, $9_2$, $10_2$; $9_2$, $10_2$, $15_2$) for determining values of a power density spectrum of the filtered received signal, a second low pass filter ($12_2$) and a second comparator ($13_2$) are connected after the second band pass filter ($6_2$) in a second signal path.

28. Device according to claim 27,
   **characterised in that**
   the first comparator ($13_1$; $13_{11}$, $13_{12}$, ..., $13_{1n}$) compares against a first threshold value and the second comparator ($13_2$) compares against a second threshold value.

29. Device according to claim 27 or 28,
   **characterised in that**
   when a plurality of comparators ($13_{11}$, $13_{12}$, ..., $13_{1n}$) are present in the first or second signal path, the comparators ($13_{11}$, $13_{12}$, ..., $13_{1n}$) of the first and second signal path are in each case connected with a logic unit (16).

30. Device according to one of claims 27 to 29,
   **characterised in that**
   the signals at the output of the first and second signal path are fed to an AND gate (14) for generating the signal for suppressing the received signal.

31. Device according to claim 24 or 25,
   **characterised in that**
   the lower and upper limit frequency of the first band pass filter unit ($6_1$) or a second band pass filter unit ($6_2$) is in each case the smallest and largest difference frequency.

32. Device according to one of claims 18 to 31, **characterised in that** a first and/or second comparator ($13_1$, $13_2$; $13_{11}$, $13_{12}$, ..., $13_{1n}$) exhibits a lower first and/or second threshold value for activating the signal for suppressing the received signal, and the first and/or second comparator ($13_1$, $13_2$; $13_{11}$, $13_{12}$, ..., $13_{1n}$) exhibits as threshold value an upper first and/or second threshold value for deactivating the signal for suppressing the received signal.


**Revendications**

1. Procédé pour activer ou désactiver un signal en vue de la suppression d'un signal de réception, qui est constitué par la superposition de plusieurs signaux de fréquences différentes et envoyés par un émetteur respectif et par un bruit, au moyen de filtres passe-bande d'un signal de réception (S40 ; S230),
   **caractérisé en ce que**
   les étapes de procédé suivantes supplémentaires sont effectuées :

   la détermination des valeurs d'un spectre de densité de puissance d'un signal de réception filtré pour chaque fréquence de différence (S70 ; S260), qui résulte respectivement de la différence entre deux fréquences respectives appartenant à un émetteur respectif,
   la comparaison des valeurs du spectre de densité de puissance sur des fréquences de différence avec une valeur de seuil (S100 ; S290) et
   l'activation du signal en vue de la suppression du signal de réception lors du dépassement de la valeur de seuil par la valeur maximale du spectre de densité de puissance et
   la désactivation du signal en vue de la suppression du signal de réception lors du dépassement de la valeur de seuil par la valeur maximale du spectre de densité de puissance (S110 ; S300).

2. Procédé selon la revendication 1, **caractérisé en ce que**
   la plus grande valeur du spectre de densité de puissance est déterminée sur les fréquences de différence et comparée à une valeur de seuil.

3. Procédé selon la revendication 1 ou 2, **caractérisé en ce que**
   les valeurs du spectre de densité de puissance sont déterminées sur les fréquences de différence sélectionnées dans une plage d'ondes fondamentales et sont comparées à une valeur de seuil respective.

4. Procédé selon la revendication 1 ou 2, **caractérisé en ce que**
   les valeurs du spectre de densité de puissance sont déterminées sur les fréquences de différence sélectionnées dans une plage d'ondes fondamentales et dans une plage d'harmoniques et sont comparées à une valeur de seuil respective.

**5.** Procédé selon l'une des revendications 1 à 4, **caractérisé en ce que** un signal définitif est généré en vue de la suppression du signal de réception par la combinaison logique des signaux générés respectivement aux sorties de plusieurs comparateurs en vue de la suppression du signal de réception (S120 ; S310).

**6.** Procédé selon l'une des revendications 1 à 5, **caractérisé en ce que** la détermination du spectre de densité de puissance du signal de réception filtré comprend les étapes de procédé suivantes :

- l'autocorrélation du signal de réception filtré (S60) et
- la détection d'une transformée de Fourier du signal de réception autocorrélé (S70).

**7.** Procédé selon l'une des revendications 1 à 5, **caractérisé en ce que** la détermination du spectre de densité de puissance du signal de réception filtré comporte les étapes de procédé suivantes :

- la détermination d'une transformée de Fourier du signal de réception filtré (S250) et
- la formation d'une valeur absolue de la transformée de Fourier détectée (S260).

**8.** Procédé selon l'une des revendications 1 à 7, **caractérisé en ce que** la valeur absolue du signal de réception est utilisée par le signal de réception.

**9.** Procédé selon l'une des revendications 1 à 8, **caractérisé en ce que** la première dérivée temporelle de la phase du signal de réception est utilisée par le signal de réception.

**10.** Procédé selon l'une des revendications 1 à 7, **caractérisé en ce que** la valeur absolue et la première dérivée temporelle de la phase du signal de réception sont utilisées simultanément et indépendamment l'une de l'autre pour le signal de réception.

**11.** Procédé selon la revendication 10, **caractérisé en ce que** le signal en vue de la suppression du signal de réception dans un trajet de signal, dans lequel la valeur du spectre de densité de puissance de la valeur absolue du signal de réception filtré est comparée à une première valeur de seuil, est combiné selon une opération ET logique pour générer un signal différent en vue de la suppression du signal de réception avec le signal en vue la suppression du signal de réception dans un trajet du signal, dans lequel la valeur du spectre de densité de puissance de la première dérivée temporelle de la phase du signal de réception filtrée est comparée à une seconde valeur de seuil.

**12.** Procédé selon l'une des revendications 1 à 11, **caractérisé en ce que** une mise à niveau automatique du signal de réception (S50 ; S240) est effectué entre le filtrage et la détection du spectre de densité de puissance du signal de réception.

**13.** Procédé selon l'une des revendications 1 à 12, **caractérisé en ce que** les fréquences limites inférieure et supérieure du filtrage par filtre passe-bande sont les fréquences de différence la plus petite et la plus grande.

**14.** Procédé selon l'une des revendications 1 à 13, **caractérisé en ce que** les différentes fréquences des signaux envoyés correspondent aux spécifications du standard Climax.

**15.** Procédé selon l'une des revendications 1 à 14, **caractérisé en ce que** en vue de l'activation du signal pour la suppression du signal de réception, une valeur de seuil inférieure ou une première valeur de seuil inférieure ou une seconde valeur de seuil inférieure est utilisée et pour désactiver le signal en vue de la suppression du signal de réception, une valeur de seuil supérieure ou une première valeur de seuil supérieure ou une seconde valeur de seuil supérieure est utilisée.

**16.** Procédé selon l'une des revendications 1 à 15, **caractérisé en ce que** un filtrage par filtre passe-bas en vue du lissage du signal du tracé temporel de la valeur du spectre de densité de puissance (S90 ; S280) est effectué avant la comparaison des valeurs de seuil.

**17.** Procédé selon l'une des revendications 1 à 16, **caractérisé en ce que**
les valeurs du spectre de densité de puissance sont déterminées en plus sur les fréquences respectives adjacentes aux fréquences de différence en vue de l'augmentation de la sélectivité de fréquences dans le cas d'oscillation de fréquences par les lignes spectrales contenues dans le spectre de densité de puissance.

**18.** Dispositif pour activer ou désactiver un signal en vue de la suppression d'un signal de réception, qui est constitué par la superposition de plusieurs signaux de fréquences différentes et envoyés par un émetteur respectif et par un bruit, comportant au moins un filtre passe-bande $(6_1, 6_2)$ pour un filtrage grâce à un filtre passe-bande un signal de réception,
**caractérisé par**
au moins une unité fonctionnelle $(8_1, 8_2, 9_1, 9_2, 10_1, 10_2 ; 9_1, 9_2, 10_1, 10_2, 15_1, 15_2)$ en vue de la détermination des valeurs d'un spectre de densité de puissance du signal de réception filtré pour chaque fréquence de différence, qui résulte de la différence entre deux fréquences respectives appartenant respectivement à un émetteur, et
au moins un comparateur $(13_1, 13_2 ; 13_{11}, 13_{12}, ..., 13_{1n})$ pour comparer les valeurs du spectre de densité de puissance sur une fréquence de différence respective à une valeur de seuil et, en vue de l'activation ou de la désactivation du signal pour supprimer le signal de réception selon le résultat du comparateur.

**19.** Dispositif selon la revendication 18, **caractérisé en ce que**
un détecteur de valeurs maximales respectif $(11_1, 11_2)$ est activé en vue de la détermination de la plus grande valeur du spectre de densité de puissance sur les différentes fréquences de différence avant au moins un comparateur $(13_1, 13_2)$.

**20.** Dispositif selon la revendication 18 ou 19, **caractérisé en ce que**
l'unité fonctionnelle $(8_1, 8_2, 9_1, 9_2, 10_1, 10_2 ; 9_1, 9_2, 10_1, 10_2, 15_1, 15_2)$ comporte un auto-corrélateur $(8_1, 8_2)$ pour auto-corréler le signal de réception filtré et un transformateur de Fourier $(9_1, 9_2)$ pour effectuer une transformée de Fourier du signal de réception auto-corrélé en vue de la détermination des valeurs d'un spectre de densité de puissance du signal de réception filtré.

**21.** Dispositif selon la revendication 18 ou 19, **caractérisé en ce que**
l'unité fonctionnelle $(8_1, 8_2, 9_1, 9_2, 10_1, 10_2 ; 9_1, 9_2, 10_1, 10_2, 15_1, 15_2)$ comporte un transformateur de Fourier $(9_1, 9_2)$ pour détecter une transformée de Fourier du signal de réception filtré et un dispositif de formation de valeur absolue $(15_1, 15_2)$ pour former les valeurs absolues de la transformée de Fourier en vue de la détermination des valeurs d'un spectre de densité de puissance du signal de réception filtré.

**22.** Dispositif selon l'une des revendications 18 à 21, **caractérisé en ce que**
un filtre passe-bas $(12_1, 12_2 ; 12_{11}, 12_{12}, ..., 12_{1n})$ en vue du lissage du signal du tracé temporel de la valeur du spectre de densité de puissance est activé avant chaque comparateur $(13_1, 13_2 ; 13_{11}, 13_{12}, ..., 13_{1n})$.

**23.** Dispositif selon l'une des revendications 18 à 22, **caractérisé en ce que**
une unité fonctionnelle respective $(7_1, 7_2)$ en vue de la mise à niveau automatique du signal de réception est interposée entre chaque filtre passe-bande $(6_1, 6_2)$ et chaque unité fonctionnelle $(8_1, 8_2, 9_1, 9_2, 10_1, 10_2 ; 9_1, 9_2, 10_1, 10_2, 15_1, 15_2)$ en vue de la détermination des valeurs d'un spectre de densité de puissance du signal de réception filtré.

**24.** Dispositif selon l'une des revendications 18 à 23, **caractérisé en ce que**
le filtre passe-bande $(6_1, 6_2)$ comporte une première unité de filtre passe-bande $(6_1)$, à laquelle la valeur absolue ou la première dérivée temporelle de la phase du signal de réception est délivrée.

**25.** Dispositif selon la revendication 24, **caractérisé en ce que**
au moins une première unité fonctionnelle $(7_1)$ en vue de la mise à niveau automatique du signal de réception, une première unité fonctionnelle $(8_1, 9_1, 10_1 ; 9_1, 10_1, 15_1)$ en vue de la détermination des valeurs d'un spectre de densité de puissance du signal de réception filtré, un premier filtre passe-bas $(12_1 ; 12_{11}, 12_{12}, ..., 12_{1n})$ et un premier comparateur $(13_1 ; 13_{11}, 13_{12}, ..., 13_{1n})$ sont placés en aval de la première unité de filtre passe-bande $(6_1)$ dans un premier trajet de signal.

**26.** Dispositif selon l'une des revendications 18 à 23, **caractérisé en ce que**

les filtres passe-bande ($6_1$, $6_2$) sont un premier filtre passe-bande ($6_1$), auquel est délivrée la valeur absolue du signal de réception, et un second filtre passe-bande ($6_2$), auquel est délivrée la première dérivée temporelle de la phase du signal de réception.

27. Dispositif selon la revendication 26, **caractérisé en ce que**
au moins une première unité fonctionnelle ($7_1$) en vue de la mise à niveau automatique du signal de réception, une première unité fonctionnelle ($8_1$, $9_1$, $10_1$ ; $9_1$, $10_1$, $15_1$) en vue de la détermination des valeurs d'un spectre de densité de puissance du signal de réception filtré, un premier filtre passe-bas ($12_1$ ; $12_{11}$, $12_{12}$,..., $12_{1n}$) et un premier comparateur ($13_1$ ; $13_{11}$, $13_{12}$,..., $13_{1n}$) sont placés en aval du premier filtre passe-bande ($6_1$) dans un premier trajet de signal et
**en ce qu'**au moins une seconde unité fonctionnelle ($7_2$) en vue de la mise à niveau automatique du signal de réception, une seconde unité fonctionnelle ($8_2$, $9_2$, $10_2$ ; $9_2$, $10_2$, $15_2$) en vue de la détermination des valeurs d'un spectre de densité de puissance du signal de réception filtré, un second filtre passe-bas ($12_2$) et un second comparateur ($13_2$) sont placés en aval du second filtre passe-bande ($6_2$) dans un second trajet de signal.

28. Dispositif selon la revendication 27, **caractérisé en ce que**
le premier comparateur ($13_1$ ; $13_{11}$, $13_{12}$,..., $13_{1n}$) compare une première valeur de seuil et le second comparateur ($13_2$) compare une seconde valeur de seuil.

29. Dispositif selon la revendication 27 ou 28, **caractérisé en ce que**
les comparateurs ($13_{11}$, $13_{12}$,..., $13_{1n}$) du premier et du second trajet de signal sont reliés respectivement à une unité logique (16) dans le cas de l'existence de plusieurs comparateurs ($13_{11}$, $13_{12}$,..., $13_{1n}$) dans le premier ou le second trajet de signal.

30. Dispositif selon l'une des revendications 27 à 29, **caractérisé en ce que**
les signaux à la sortie du premier et du second trajet du signal sont délivrés à une fonction logique ET (14) en vue de la génération du signal pour supprimer le signal de réception.

31. Dispositif selon la revendication 24 ou 25, **caractérisé en ce que**
les fréquences limites inférieure et supérieure de la première unité de filtre passe-bande ($6_1$) ou de la seconde unité de filtre passe-bande ($6_2$) sont respectivement les fréquences de différence la plus petite et la plus grande.

32. Dispositif selon l'une des revendications 18 à 31, **caractérisé en ce que**
un premier et/ou un second comparateur ($13_1$, $13_2$ ; $13_{11}$, $13_{12}$,..., $13_{1n}$) présente une première et/ou seconde valeur de seuil inférieure pour activer le signal en vue de la suppression du signal de réception et le premier et/ou le second comparateur ($13_1$, $13_2$ ; $13_{11}$, $13_{12}$,..., $13_{1n}$) présente une première et/ou seconde valeur de seuil supérieure en tant que valeur de seuil pour désactiver le signal en vue de la suppression du signal de réception.

| Anzahl der Frequenzen / Frequenzen | Sender-frequenz 1 | Sender-frequenz 2 | Sender-frequenz 3 | Sender-frequenz 4 | Sender-frequenz 5 |
|---|---|---|---|---|---|
| 2 | 8,33 kHz Bandbreite: $f_C - 2{,}5$ kHz | $f_C + 2{,}5$ kHz | | | |
| 2 | 25 kHz Bandbreite: $f_C - 5$ kHz | $f_C + 5$ kHz | | | |
| 3 | $f_C - 7{,}3$ kHz | $f_C$ | $f_C + 7{,}3$ kHz | | |
| 4 | $f_C - 7{,}5$ kHz | $f_C - 2{,}5$ kHz | $f_C + 2{,}5$ kHz | $f_C + 7{,}5$ kHz | |
| 5 | $f_C - 8$ kHz | $f_C - 4$ kHz | $f_C$ | $f_C + 4$ kHz | $f_C + 8$ kHz |

## Fig. 1

Fig. 2A

EP 2 333 953 B1

Fig. 2B

Fig. 3A

Fig. 3B

Start

Analog-Digital-Wandeln des Empfangssignals — S10

Mischen des Empfangssignals ins Basisband — S20

Ermitteln von Betrag und erster zeitlicher Ableitung
der Phase des Empfangssignals — S30

Bandpassfiltern des Empfangssignals — S40

Automatisches Regeln des Signalpegels des Empfangssignals — S50

Autokorrelieren des Empfangssignals — S60

Ermitteln des Leistungsdichtespektrums des Empfangssignals
an den einzelnen Differenzfrequenzen mittels Fourier-Transformieren
der Autokorrelationsfunktion — S70

Ermitteln des maximalen Werts des Leistungsdichtespektrums
an den einzelnen Differenzfrequenzen — S80

Tiefpassfiltern des zeitlichen Verlaufs des maximalen
Werts des Leistungsdichtespektrum — S90

Vergleichen des maximalen Werts des Leistungsdichtespektrums
mit oberen bzw. unteren Schwellwert — S100

Aktivieren des Signals zur Unterdrückung des Empfangssignals,
falls maximaler Wert des Leistungsdichtespektrums kleiner als
unterer Schwellwert ist — S110

Logisches Und-Verknüpfen der beiden Vergleicher-Ausgangssignale im Fall der gleichzetigen Verwendung von Betrag und
zeitlicher Ableitung der Phase des Empfangssignals — S120

Ende

Fig. 4A

```
                    ┌──────────┐
                    │  Start   │
                    └──────────┘
                          │
                          ▼
  ┌──────────────────────────────────────────────────┐
  │    Analog-Digital-Wandeln des Empfangssignals     │──── S200
  └──────────────────────────────────────────────────┘
                          │
                          ▼
  ┌──────────────────────────────────────────────────┐
  │      Mischen des Empfangssignals ins Basisband    │──── S210
  └──────────────────────────────────────────────────┘
                          │
                          ▼
  ┌──────────────────────────────────────────────────┐
  │   Ermitteln des Betrags und der ersten zeitlichen │
  │         Ableitung der Phase des Empfangssignals    │──── S220
  └──────────────────────────────────────────────────┘
                          │
                          ▼
  ┌──────────────────────────────────────────────────┐
  │       Bandpassfiltern des Empfangssignals         │──── S230
  └──────────────────────────────────────────────────┘
                          │
                          ▼
  ┌──────────────────────────────────────────────────┐
  │  Automatisches Regeln des Signalpegels des        │
  │              Empfangssignals                       │──── S240
  └──────────────────────────────────────────────────┘
                          │
                          ▼
  ┌──────────────────────────────────────────────────┐
  │ Ermitteln der Fourier-Transformierten des         │
  │ gefilterten Empfangssignals                        │──── S250
  │ an den einzelnen Differenzfrequenzen               │
  └──────────────────────────────────────────────────┘
                          │
                          ▼
  ┌──────────────────────────────────────────────────┐
  │ Ermitteln des Leistungsdichtespektrums des        │
  │ Empfangssignals an den einzelnen                   │
  │ Differenzfrequenzen durch Betragsbilden des        │──── S260
  │ der ermittelten Fourier-Transformierten            │
  └──────────────────────────────────────────────────┘
                          │
                          ▼
  ┌──────────────────────────────────────────────────┐
  │ Ermitteln des maximalen Werts des                  │
  │ Leistungsdichtespektrums                           │──── S270
  │ an den einzelnen Differenzfrequenzen               │
  └──────────────────────────────────────────────────┘
                          │
                          ▼
  ┌──────────────────────────────────────────────────┐
  │ Tiefpassfiltern des zeitlichen Verlaufs des       │
  │ maximalen Werts des Leistungsdichtespektrums       │──── S280
  └──────────────────────────────────────────────────┘
                          │
                          ▼
  ┌──────────────────────────────────────────────────┐
  │ Vergleichen des maximalen Werts des               │
  │ Leistungsdichtespektrums                           │──── S290
  │ mit oberen bzw. unteren Schwellwert                │
  └──────────────────────────────────────────────────┘
                          │
                          ▼
  ┌──────────────────────────────────────────────────┐
  │ Aktivieren / Deaktivieren des Signals zur         │
  │ Unterdrückung des Empfangssignals bei             │
  │ Schwellwert unter-/überschreitung durch            │──── S300
  │ maximalen Wert des Leistungsdichtespektrums        │
  └──────────────────────────────────────────────────┘
                          │
                          ▼
  ┌──────────────────────────────────────────────────┐
  │ Logisches Und-Verknüpfen der beiden               │
  │ Vergleicher-Ausgangssignale im Fall               │
  │ gleichzetiger Verwendung von Betrag und            │──── S310
  │ zeitlicher Ableitung der Phase des Empfangssignals │
  └──────────────────────────────────────────────────┘
                          │
                          ▼
                    ┌──────────┐
                    │   Ende   │
                    └──────────┘
```

Fig. 4B

Signalpegel

Anzahl der
Abtastpunkte

Fig. 5

Betrag des
Empfangssignals

dBV

Frequenz

Fig. 6A

Fig. 6B

Fig. 7A

Fig. 7B

Fig. 8

Fig. 9

Fig. 10

Fig. 11

Pegel des
Leistungsdichtespektrums

Fig. 12

Fig. 13

Fig. 14A

Fig. 14B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1843467 A2
- US 4371981 A
- US 4388731 A
- US 5365592 A